# EUROPEAN PATENT APPLICATION

(11) **EP 4 742 849 A1**
(43) Date of publication of application: **13.05.2026**
(21) Application number: 25197810.2
(22) Date of filing: 25.08.2025
(51) Int. Cl.: H10B 41/10, H10B 43/10, H10B 41/27, H10B 43/27, H10B 80/00, H10P 74/20

(54) **SEMICONDUCTOR DEVICES AND DATA STORAGE SYSTEMS INCLUDING THE SAME**

(30) Priority: 07.11.2024 KR 20240157340
(71) Applicant: Samsung Electronics Co., Ltd., Suwon-si, Gyeonggi-do 16677 (KR)
(72) Inventor: PARK, Byunggon, 16677 Suwon-si, Gyeonggi-do (KR); OH, Hyunsyek, 16677 Suwon-si, Gyeonggi-do (KR); PARK, Junbeom, 16677 Suwon-si, Gyeonggi-do (KR); SHIN, Yongjoon, 16677 Suwon-si, Gyeonggi-do (KR); OH, Soosik, 16677 Suwon-si, Gyeonggi-do (KR); KIM, Moongeun, 16677 Suwon-si, Gyeonggi-do (KR)
(74) Representative: Kuhnen & Wacker Patent- und Rechtsanwaltsbüro PartG mbB

(57) **Abstract**

A semiconductor device includes a first semiconductor structure (S1) and a second semiconductor structure (S2). The first semiconductor structure (S1) includes circuit elements (120) on a first substrate (101), a lower interconnection structure (130) coupled with the circuit elements (120), and a lower bonding structure (180) coupled with the lower interconnection structure (130). The second semiconductor structure (S2) includes an upper bonding structure (280) bonded to the lower bonding structure (180), a conductive layer (201), a stack structure (GS1, GS2) including interlayer insulating layers (220) and gate electrodes (230), a plurality of separation regions (MS) at least partially penetrating through the stack structure (GS1, GS2), channel structures (CH) including a channel layer and at least partially penetrating through the stack structure (GS1, GS2), a plurality of address studs (275) spaced apart from each other by a first separation distance, a plurality of channel studs (272) below the channel structures (CH), and an upper interconnection structure (271, 273, 274) below the stack structure (GS1, GS2), coupled with the plurality of channel studs (272), and spaced apart from the plurality of address studs (275).

## Description

### BACKGROUND

### 1. Field

The present disclosure relates generally to semiconductor devices, and more particularly, to a semiconductor device and data storage systems including the same.

### 2. Description of Related Art

Data storage systems, which may need data storage, may use a semiconductor device that may be capable of storing a relatively large amount of data. Accordingly, approaches for potentially increasing the data storage capacity of a semiconductor device may have been researched. For example, a possible approach for potentially increasing the data storage capacity of a semiconductor device may include three-dimensionally arranging memory cells of a semiconductor device, rather than arranging the memory cells two-dimensionally.

### SUMMARY

One or more example embodiments of the present disclosure may provide a semiconductor device having a relatively high reliability compared to a related semiconductor device and a data storage system including such a semiconductor device.

One or more example embodiments of the present disclosure may provide a semiconductor device that has structural features that can be used for improving error inspection and consequently for improving the reliability of the device, and a data storage system including such a semiconductor device.

According to an aspect of the present disclosure, a semiconductor device includes a first semiconductor structure and a second semiconductor structure. The first semiconductor structure includes a first substrate, circuit elements on the first substrate, a lower interconnection structure coupled with the circuit elements, and a lower bonding structure coupled with the lower interconnection structure. The second semiconductor structure includes an upper bonding structure bonded to the lower bonding structure, a conductive layer, a stack structure including interlayer insulating layers and gate electrodes laminated in a first direction below the conductive layer, a plurality of separation regions at least partially penetrating through the stack structure, extending in a second direction, and spaced apart from each other in a third direction, channel structures including a channel layer and at least partially penetrating through the stack structure in the first direction, a plurality of address studs spaced apart from each other by a first separation distance in the second direction below at least one separation region of the plurality of separation regions, a plurality of channel studs below the channel structures, and an upper interconnection structure below the stack structure, coupled with the plurality of channel studs, and spaced apart from the plurality of address studs. The first direction is perpendicular to an upper surface of the conductive layer. The second direction is perpendicular to the first direction. The third direction is perpendicular to the first direction and the second direction.

According to an aspect of the present disclosure, a semiconductor device includes a first semiconductor structure and a second semiconductor structure. The first semiconductor structure includes a first substrate, circuit elements on the first substrate, a lower interconnection structure coupled with the circuit elements, and a lower bonding structure coupled with the lower interconnection structure. The second semiconductor structure includes an upper bonding structure bonded to the lower bonding structure, a conductive layer, a stack structure including interlayer insulating layers and gate electrodes stacked in a first direction below the conductive layer, channel structures including a channel layer and at least partially penetrating through the stack structure in the first direction, a plurality of separation regions at least partially penetrating through the stack structure, extending in a second direction, and spaced apart from each other in a third direction, a plurality of address studs spaced apart from each other by multiples of a unit separation distance in the second direction, and disposed below the first address separation regions and the second address separation regions, and a plurality of channel studs disposed below the channel structures. The first direction is perpendicular to an upper surface of the conductive layer. The second direction is perpendicular to the first direction. The third direction is perpendicular to the first direction and the second direction. The plurality of separation regions include address separation groups including first address separation regions and second address separation regions adjacent to the first address separation regions in the third direction.

According to an aspect of the present disclosure, a data storage system includes a semiconductor storage device and a controller coupled with the semiconductor storage device via an input/output pad and configured to control the semiconductor storage device. The semiconductor storage device includes a first semiconductor structure including a substrate and circuit elements on the substrate, a second semiconductor structure including a stack structure including interlayer insulating layers and gate electrodes stacked in a first direction and channel structures at least partially penetrating through the stack structure, and the input/output pad coupled with the circuit elements. The first semiconductor structure further includes a lower interconnection structure coupled with the circuit elements, and a lower bonding structure coupled with the lower interconnection structure. The second semiconductor structure further includes an upper interconnection structure disposed below the stack structure, an upper bonding structure coupled with the upper interconnection structure and bonded to the lower bonding structure, a plurality of separation regions at least partially penetrating through the stack structure and extending in a second direction, and spaced apart from each other in a third direction, a plurality of address studs disposed below at least one separation region of the plurality of separation regions and spaced apart from each other by a first separation distance in the second direction, and a plurality of channel studs below the channel structures. The upper interconnection structure is coupled with the plurality of channel studs and spaced apart from the plurality of address studs. The second direction is perpendicular to the first direction. The third direction is perpendicular to the first direction and the second direction.

Advantages and effects of the present application are not limited to the foregoing content and may be more easily understood in the process of describing a specific example embodiment of the present disclosure.

Additional aspects may be set forth in part in the description which follows and, in part, may be apparent from the description, and/or may be learned by practice of the presented embodiments.

### BRIEF DESCRIPTION OF DRAWINGS

The above and other aspects, features, and advantages of certain embodiments of the present disclosure may be more apparent from the following description taken in conjunction with the accompanying drawings, in which:
FIG. 1 is a schematic plan view of a semiconductor device, according to example embodiments;
FIG. 2 is a partially enlarged view of a semiconductor device within region A in Fig. 1, according to example embodiments;
FIG. 3 is a schematic cross-sectional view of a semiconductor device taken along the line I-I' in FIG.2, according to example embodiments;
FIG. 4A and FIG. 4B are enlarged cross-sectional views of the partial regions B and C of FIG. 3, according to example embodiments;
FIG. 5 to FIG. 7 are enlarged views of a semiconductor device, according to example embodiments;
FIG. 8 is a plan view of a semiconductor device, according to example embodiments;
FIG. 9 is a schematic cross-sectional view of a semiconductor device, according to example embodiments;
FIG. 10 to FIG. 13 are schematic partially enlarged views of a semiconductor device, according to example embodiments;
FIG. 14A to FIG. 14G are schematic cross-sectional views illustrating a method of manufacturing a semiconductor device, according to example embodiments;
FIG. 15 is a schematic view of a data storage system including a semiconductor device, according to example embodiments; and
FIG. 16 is a perspective view schematically illustrating a data storage system including a semiconductor device, according to example embodiments.

### DETAILED DESCRIPTION

The following description with reference to the accompanying drawings is provided to assist in a comprehensive understanding of embodiments of the present disclosure defined by the appended claims. Various specific details are included to assist in understanding, but these details are considered to be exemplary only. Therefore, those of ordinary skill in the art may recognize that various changes and modifications of the embodiments described herein may be made within the scope of the appended claims. In addition, descriptions of well-known functions and structures are omitted for clarity and conciseness.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wired), wirelessly, or via a third element.

It is to be understood that when an element or layer is referred to as being "over," "above," "on," "below," "under," "beneath," "connected to" or "coupled to" another element or layer, it may be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

The terms "upper," "middle", "lower", or the like may be replaced with terms, such as "first," "second," third" to be used to describe relative positions of elements. The terms "first," "second," third" may be used to describe various elements but the elements are not limited by the terms and a "first element" may be referred to as a "second element". Alternatively or additionally, the terms "first", "second", "third", or the like may be used to distinguish components from each other and do not limit the present disclosure. For example, the terms "first", "second", "third", or the like may not necessarily involve an order or a numerical meaning of any form.

As used herein, when an element or layer is referred to as "covering", "overlapping", or "surrounding" another element or layer, the element or layer may cover at least a portion of the other element or layer, where the portion may include a fraction of the other element or may include an entirety of the other element. Similarly, when an element or layer is referred to as "penetrating" another element or layer, the element or layer may penetrate at least a portion of the other element or layer, where the portion may include a fraction of the other element or may include an entire dimension (e.g., length, width, depth) of the other element.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout this disclosure may, but do not necessarily, all refer to the same embodiment. The embodiments described herein are example embodiments, and thus, the disclosure is not limited thereto and may be realized in various other forms.

The embodiments herein may be described and illustrated in terms of blocks, as shown in the drawings, which carry out a described function or functions. These blocks, which may be referred to herein as units or modules or the like, or by names such as device, logic, circuit, controller, counter, comparator, generator, converter, or the like, may be physically implemented by analog and/or digital circuits including one or more of a logic gate, an integrated circuit, a microprocessor, a microcontroller, a memory circuit, a passive electronic component, an active electronic component, an optical component, or the like.

In the present disclosure, the articles "a" and "an" are intended to include one or more items, and may be used interchangeably with "one or more." Where only one item is intended, the term "one" or similar language is used. For example, the term "a processor" may refer to either a single processor or multiple processors. When a processor is described as carrying out an operation and the processor is referred to perform an additional operation, the multiple operations may be executed by either a single processor or any one or a combination of multiple processors.

As used herein, each of the terms "SiC", "SiCN", "SiGe", "Si₃N₄", "SiO₂", "SiOC", "SiOCN", "SiON", "TaN", "TaSiN", "TiN", "TiSiN", "WN", "WSiN", or the like may refer to a material made of elements included in each of the terms and is not a chemical formula representing a stoichiometric relationship.

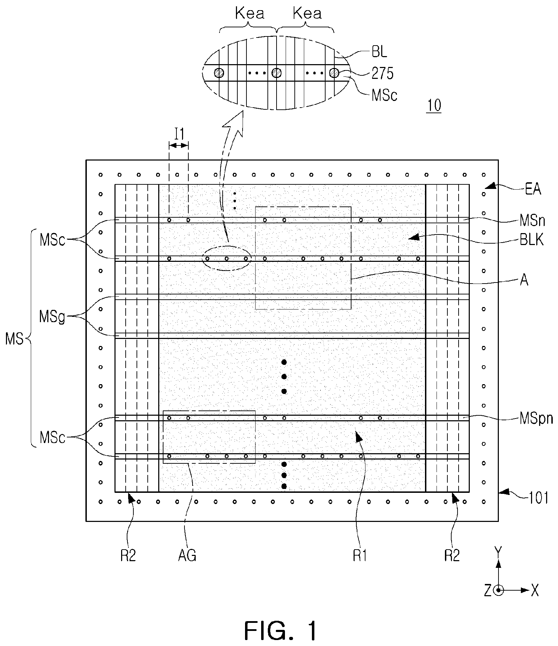

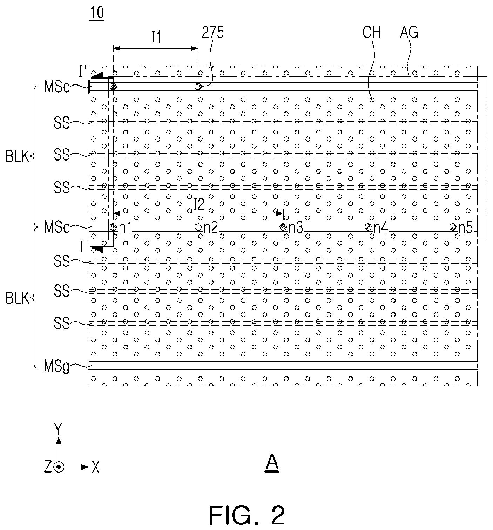

Hereinafter, semiconductor devices, according to example embodiments are described with reference to FIGS. 1 to 4B. FIG. 1 is a schematic plan view of a semiconductor device, according to example embodiments. FIG. 2 is an enlarged plan view of region A of FIG. 1, according to example embodiments.

A semiconductor device 10 may include a first semiconductor structure S1 and a second semiconductor structure S2, and the first semiconductor structure S1 may be stacked in a Z-direction (e.g. a first direction), which is a vertical direction with respect to the second semiconductor structure S2. For example, the first semiconductor structure S1 may be disposed below the second semiconductor structure S2 in the Z-direction. As another example, the second semiconductor structure S2 may be disposed below the first semiconductor structure S1.

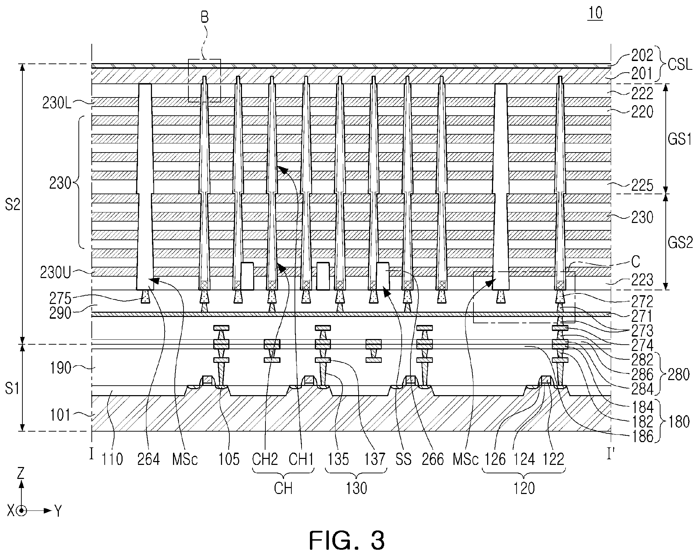

In an example embodiment, the semiconductor device 10 may include a peripheral circuit structure (e.g., a peripheral circuit structure PERI of FIG. 3) that may be a first semiconductor structure S1 in which a peripheral circuit region is formed on a first substrate 101, and a memory cell structure (e.g., a memory cell structure CELL of FIG. 3) that may be a second semiconductor structure S2 including a common source line CSL.

The first semiconductor structure S1 may form a peripheral circuit by forming transistors and/or metal patterns for wiring the transistors on the first substrate 101. The second semiconductor structure S2 of the semiconductor device 10 may include memory blocks BLK that may be and/or may include a set of a plurality of channel structures CH.

The semiconductor device 10 may include a first region R1 in an X-direction (e.g. a second direction) and a second region R2 on both sides of the first region R1.

The first region R1 may correspond to a memory cell region in which memory cells are disposed, and may be a region in which channel structures CH are disposed. The second region R2 may correspond to a region for electrically connecting the memory cells to the peripheral circuit structures PERI, and thereby, the second region R2 may be and/or may include a region in which gate electrode layers may extend by different lengths. However, the present disclosure is not limited thereto.

Referring to FIG. 1, an edge region EA may be disposed on each side. The edge region EA may be disposed on the outside of the second region R2, an upper portion and a lower portion of the first region R1, and may be a region in which a mold structure remains. The edge region EA may refer to a region in which a pad region connected from the outside is disposed, external contact vias connected to the pad region are disposed, or various through-vias connected to the first semiconductor structure S1 are disposed. Although the semiconductor device 10 is illustrated as being disposed to have a frame shape by disposing edge regions EA on each side thereof, the present disclosure not limited thereto.

The semiconductor device 10 may have separation regions MS extending in the X-direction within the first region R1 and the second region R2. The separation regions MS may be spaced apart from each other in a Y-direction (e.g. a third direction), and the first region R1 between the adjacent separation regions MS may be referred to as one memory block BLK. The memory block BLK may be utilized as an operation unit of the channel structures CH and a signal application unit. However, the present disclosure is not limited thereto.

A plurality of memory blocks BLK may be disposed within the first region R1 of the semiconductor device 10. For example, tens to hundreds of memory blocks BLK may be disposed within the first region R1. However, the present disclosure is not limited in this regard. Address studs 275 may be disposed by corresponding to at least some of the separation regions MS separating the memory blocks BLK.

The separation regions MS in which the address studs 275 are disposed may be referred to as address separation regions MSc. The separation regions disposed every n-th separation region in the Y-direction from among the separation regions MS (e.g., an n-th separation region, a 2n-th separation region, a 3n-th separation region, or the like, where n is a positive integer greater than zero (0)) may be referred to as address separation regions MSc. The remaining separation regions MS that are not address separation regions MSc may be referred to as general separation regions MSg, and may be separation regions MS in which the address studs 275 are not disposed in a lower portion.

The address separation regions MSc may be disposed in pairs and/or as a group. That is, the adjacent separation regions MS disposed above and below one memory block BLK may be address separation regions MSc. That is, n may be a predetermined number such as, but not limited to, 50, 100, or the like. For example, when n is 50, 50th and 51st address separation regions MSc may form a pair, and 100th and 101st address separation regions MSc may form another pair.

The address studs 275 disposed on a pair of address separation regions MSc may be disposed regularly according to an array rule. The address studs 275 may be arranged in two (2) rows on a pair of address separation regions MSc. One row of address studs 275 may be arranged on each address separation region MSc forming a pair of address separation regions MSc.

In a pair of address separation regions MSc, the address studs 275 of each column may be arranged in different numbers. For example, if the number of address studs 275 in a first row is at least a, the number of address studs 275 in a second row may be b-(a-1). In such an example, b may be the number of stud positions (e.g., a first stud position n1, a second stud position n2, a third stud position n3, a fourth stud position n4, and a fifth stud position n5) within an array group AG, which may be a set of address studs 275 to which an array rule is applied. The stud positions n1 to n5 may refer to positions that may be spaced apart from each other by the same separation distance I1. For example, the separation distance I1 may be determined based on the sum of pitches (multiples of pitches) of a predetermined number k of bit lines BL. The stud positions n1 to n5 may refer to positions in which the address studs 275 may be disposed within the array group AG, and the same stud positions n1 to n5 aligned in the Y-direction may be set for each row. Accordingly, the address studs 275 may be spaced apart from each other by an integer multiple r (where r is a positive integer greater than zero (0)) of the separation distance on the address separation regions MSc.

In some embodiments, k may be 50, 100, or the like. For example, when the number of stud positions n1 to n5 within the array group AG, b, is five (5), the number a of address studs 275 in the first row may be two (2), and the number of the address studs 275 of the second row may satisfy four (4).

The array group AG may be repeatedly disposed in an extension direction (X-direction) of a pair of address separation regions MSc. The array rules of each array group AG may be substantially similar and/or identical to each other, and the same array of address studs 275 following the same array rule may be repeatedly disposed on a pair of address separation regions MSc. Additionally, the same array rule may be applied to other pairs of address separation regions MSc.

As illustrated in FIG. 1 and FIG. 2, when five stud positions n1 to n5 are set in one row within one array group AG, the address studs 275 may be disposed in the first and second stud positions n1 and n2 in the first row, and the address studs 275 may be disposed in the first stud position n1, the third stud position n3, the fourth stud position n4, and the fifth stud position in the second row. That is, the address stud 275 may be disposed in the first row in the second stud position n2, so that a start address stud 275 and a next address stud 275 in the second row may be spaced apart from each other by a second separation distance I2, which may be twice the first separation distance I1 (e.g., I2 = 2 × I1).

That is, a position in which the address studs 275 are disposed in two rows may be referred to as the first stud position n1, and the address studs 275 disposed in two rows may be referred to as the start address studs 275. A position in which the address stud 275 is disposed only in the first row may be read as the second stud position n2, a position in which the address stud 275 adjacent to the second stud position n2 is disposed in the second row may be read as the third stud position n3, a position of the address stud 275 in the second row disposed to the left of the start address studs 275 of an adjacent array group AG may be read as the fifth position n5, and a position of the stud 275 in the second row between the third and fifth stud positions n3 and n5 may be read as the fourth stud position n4. Additionally or alternatively, since the address separation region MSc may be regularly disposed within the entire separation regions MS, the position of the address separation region MSc may be counted.

Accordingly, during error inspection, by confirming an arrangement of the address studs 275 and the position of the address separation regions MSc in which the address studs 275 are disposed, it may be possible to confirm the position in which errors occur, that is, to confirm which number of memory blocks BLK are located within a position of an error point in the Y-direction and which number of bit line BL are located within the position of the error point is in the X-direction.

Hereinafter, example embodiments of the present disclosure are described with reference to FIGS. 2 to 4B.

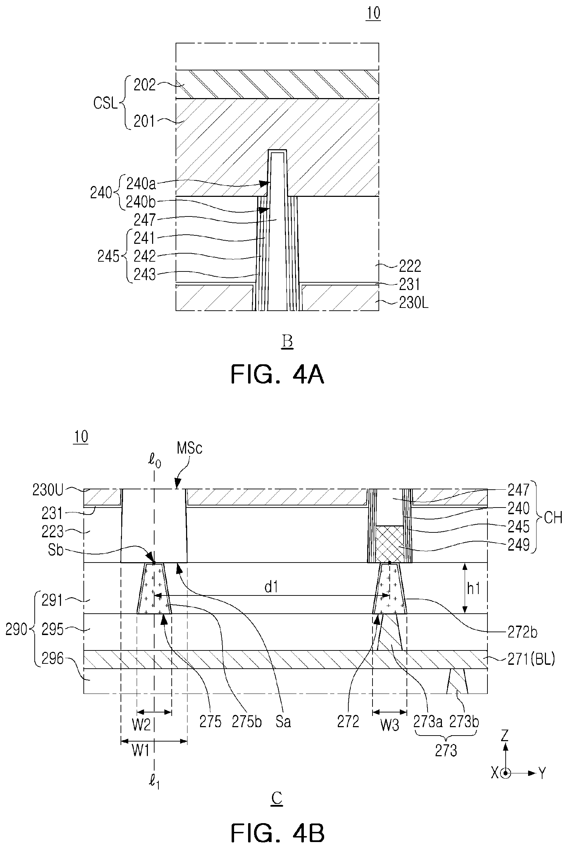

FIG. 2 is a partially enlarged view of a semiconductor device, according to example embodiments. FIG. 3 is a schematic cross-sectional view of a semiconductor device, according to example embodiments. FIGS. 4A and 4B are partially enlarged views of a semiconductor device, according to example embodiments. FIG. 2 is an enlarged view of region A of FIG. 1, and FIG. 3 illustrates a cross-section along cutting line I-I' of FIG. 2. FIGS. 4A and 4B are enlarged views of regions B and C of FIG. 3, respectively.

Referring to FIGS. 2 to 4B, the semiconductor device 10 may include a first semiconductor structure S1 referred to as a peripheral circuit structure PERI and a second semiconductor structure S2 referred to as a memory cell structure CELL on the first semiconductor structure S1. The first semiconductor structure S1 and the second semiconductor structure S2 may be bonded to each other through bonding structures (e.g., a lower bonding structure 180 and am upper bonding structure 280).

The first semiconductor structure S1 may include a first substrate 101, circuit elements 120 on the first substrate 101, a lower interconnection structure 130, the lower bonding structure 180, and a lower capping layer 190.

The first substrate 101 may include a semiconductor material, such as, but not limited to, a group IV semiconductor, a group III-V compound semiconductor, or a group II-VI compound semiconductor. The first substrate 101 may be provided as a bulk wafer or an epitaxial layer. An active region may be defined by device isolating layers 110 in the first substrate 101. Source/drain regions 105 including impurities may be disposed in a portion of the active region.

The circuit elements 120 may include a transistor. Each of the circuit elements 120 may include a circuit gate dielectric layer 122, a circuit gate electrode 124, a spacer layer 126, and a source/drain region 105. The source/drain regions 105 including impurities may be disposed in the first substrate 101 on both sides of the circuit gate electrode 124. The spacer layers 126 may be disposed on both sides of the circuit gate electrode 124. The circuit gate dielectric layer 122 may include, but not be limited to, silicon oxide (SiO₂), silicon nitride (Si₃N₄), or a high-κ material. The circuit gate electrode 124 may include, but not be limited to, at least one of doped silicon, titanium nitride (TiN), tantalum nitride (TaN), tungsten nitride (WN), titanium silicon nitride (TiSiN), tantalum silicon nitride (TaSiN), tungsten silicon nitride (WSiN), tungsten (W), copper (Cu), aluminum (Al), molybdenum (Mo), ruthenium (Ru), or the like. For example, the circuit gate electrode 124 may include a doped polycrystalline silicon layer. According to an example embodiment, the circuit gate electrode 124 may be formed of two (2) or more multilayers.

The lower interconnection structure 130 may be electrically connected to the circuit gate electrodes 124 and the source/drain regions 105 of the circuit elements 120. The lower interconnection structure 130 may include lower contact plugs 135 and lower interconnection lines 137 in which at least one region thereof may have a line shape. Some of the lower contact plugs 135 may be connected to the source/drain regions 105, and other of the lower contact plugs 135 may be connected to the gate electrodes 124. The lower contact plugs 135 may electrically connect the lower interconnection lines 137 disposed on different levels from an upper surface of the first substrate 101 to each other. The lower interconnection structure 130 may include a conductive material, such as, but not limited to, tungsten (W), copper (Cu), and aluminum (Al), or the like. Each of the components may further include a diffusion barrier including at least one of titanium (Ti), titanium nitride (TiN), tantalum (Ta), tantalum nitride (TaN), or tungsten nitride (WN). According to example embodiments, the number of layers of the lower contact plugs 135 and the lower interconnection lines 137 included in the lower interconnection structure 130 and an arrangement shape thereof may be variously changed.

The lower bonding structure 180 may be connected to the lower interconnection structure 130. The lower bonding structure 180 may include a lower bonding via 182, a lower bonding pad 184, and a lower bonding insulating layer 186. The lower bonding via 182 may be connected to the lower interconnection structure 130. The lower bonding pad 184 may be connected to the lower bonding via 182. The lower bonding via 182 and the lower bonding pad 184 may include a conductive material, such as, but not limited to, tungsten (W), copper (Cu), aluminum (Al), or the like. Each of the components may further include a diffusion barrier. The lower bonding insulating layer 186 may also function as a diffusion barrier of the lower bonding pad 184 and may include, but not be limited to, at least one of silicon oxide (SiO₂), silicon nitride (Si₃N₄), silicon oxynitride (SiON), or silicon oxycarbide (SiOC).

The lower bonding insulating layer 186 may have a thickness thinner (less) than the thickness of the lower bonding pad 184. However, the present disclosure is not limited thereto. The lower bonding structure 180 may be directly bonded and/or connected to an upper bonding structure 280 by hybrid bonding. For example, the lower bonding pad 184 may be in contact with an upper bonding pad 284 and may be bonded thereto by copper-to-copper (Cu-to-Cu) bonding, and the lower bonding insulating layer 186 may be in contact with an upper bonding insulating layer 286 and may be bonded thereto by dielectric-to-dielectric bonding. The lower bonding structure 180 may provide an electrical connection path between the peripheral circuit structure PERI S1 and the memory cell structure CELL S2 together with the upper bonding structure 280.

The lower capping layer 190 may be disposed on the first substrate 101 to cover the circuit elements 120 and the lower interconnection structure 130. The lower capping layer 190 may include a plurality of insulating layers. The lower capping layer 190 may include an insulating material, and may include, for example, silicon oxide (SiO₂), silicon nitride (Si₃N₄), silicon oxynitride (SiON), or silicon oxycarbide (SiOC).

The second semiconductor structure S2, which may be and/or may include a memory cell structure, may include a first conductive layer 201 in the first region R1 (e.g., a memory cell region), a second conductive layer 202 on an upper surface of the first conductive layer 201, gate electrodes 230 stacked on a lower surface of the first conductive layer 201, and disposed in the first region R1 and the second region R2, interlayer insulating layers 220 alternately stacked (e.g. laminated) with the gate electrodes 230, channel structures CH disposed to penetrate through the gate electrodes 230, separation regions MS extending in one direction by penetrating through the gate electrodes 230, and insulating regions SS penetrating through portions of the gate electrodes 230. The second semiconductor structure S2 may include an edge region EA surrounding the first region R1 and the second region R2. The second semiconductor structure S2 may further include an upper capping layer 290 covering the gate electrodes 230. The gate electrodes 230 may be vertically spaced apart from each other and stacked on the lower surface of the first conductive layer 201, thus forming stack structures (e.g., a first stack structure GS1 and a second stack structure GS2) together with the interlayer insulating layers 220.

The second semiconductor structure S2 may include channel studs 272 for electrical connection with the first semiconductor structure S1, upper interconnection structures (e.g., a first upper interconnection line 271, connecting vias 273, and a second upper interconnection line 274) below the first and second stack structures GS1 and GS2, and an upper bonding structure 280 connected to the upper interconnection structures 271 to 274 (e.g., the first upper interconnection line 271, the connecting vias 273, the second upper interconnection line 274, and the channel stud 272). The second semiconductor structure S2 may include address studs 275 disposed on a substantially similar and/or the same level as the channel studs 272 and disposed on the address separation regions MSc among the separation regions MS.

The second semiconductor structure S2 may further include contact plugs in the second region R2 and external contact vias in the edge region EA.

As shown in FIG. 2, the first region R1 may be a region in which the gate electrodes 230 are stacked and spaced apart from each other in the vertical direction (e.g., the Z-direction), and the channel structures CH are disposed. The second region R2 may be disposed on both sides of the first region R1 in the X-direction, as illustrated in FIG. 1, and may be a region in which the contact plugs connected to the gate electrodes 230 respectively and electrically connecting the memory cells to the first semiconductor structure S1 are disposed.

The first and second stack structures GS1 and GS2 may include a plurality of stack structures GS1 and GS2 that may be vertically stacked. In FIG. 3, lower and upper stack structures GS1 and GS2 are illustrated as being included. However, the present disclosure is not limited thereto, and three (3) to five (5)-stage stack structures GS1 to GSd may be included, where d is a positive integer greater than one (1). However, according to example embodiments, the stack structures GS1 to GSd may be formed as a single stack structure.

The gate electrodes 230 may include at least one lower gate electrode 230L included in a gate of a ground selection transistor, memory gate electrodes 230M included in a plurality of memory cells, and upper gate electrodes 230U included in gates of string selection transistors. As used herein, the lower gate electrode 230L and the upper gate electrodes 230U may be referred to as "lower" and "upper" based on a direction during the manufacturing process. The number of memory gate electrodes 230M included in the memory cells may be determined according to the capacity of the semiconductor device 10. According to an example embodiment, the upper and lower gate electrodes 230U and 230L may be 1, 2, or more, respectively, and may have a structure substantially similar and/or identical to or different from that of the memory gate electrodes 230M. In an example embodiment, erase gate electrodes may be further disposed below the upper gate electrodes 230U. Additionally, some of the gate electrodes 230, for example, memory gate electrodes 230M adjacent to the upper or lower gate electrodes 230U and 230L, may be dummy gate electrodes. However, the present disclosure is not limited thereto.

The gate electrodes 230 may be disposed to be separated from each other in the Y-direction by separation regions MS extending continuously within the first region R1 and the second region R2. The gate electrodes 230 between a pair of separation regions MS may be included in one memory block BLK. Some of the gate electrodes 230, for example, the memory gate electrodes 230M, may each form one layer within one memory block BLK.

The gate electrodes 230 may be stacked vertically and spaced apart from each other in the first region R1 and the second region R2, and may extend from the first region R1 to the second region R2 by different lengths to form a portion of the second region R2 (e.g., a staircase-shaped step structure in the second region R2). Due to the step structure, the gate electrodes 230 may have regions in which the lower gate electrode 230 extends to be longer than the upper gate electrode 230, and upper surfaces thereof are exposed upwardly from the interlayer insulating layers 220 and other gate electrodes 230, and the regions may be referred to as pad regions. In each gate electrode 230, the pad region may be a region including an end of the gate electrode 230 in the X-direction. The gate electrodes 230 may be respectively connected to the contact plugs in the pad regions.

The gate electrodes 230 may include a metal material, for example, tungsten (W). According to an example embodiment, the gate electrodes 230 may include polycrystalline silicon, a metal silicide material, or the like. According to example embodiments, the gate electrodes 230 may further include a diffusion barrier 231, and for example, the diffusion barrier 231 may include tungsten nitride (WN), tantalum nitride (TaN), titanium nitride (TiN), or combinations thereof.

The interlayer insulating layers 220 may be disposed between the gate electrodes 230 and may be included in the first and second stack structures GS1 and GS2. The interlayer insulating layers 220 may also be spaced apart from each other in a direction, perpendicular to the lower surface of the first conductive layer 201, and may extend in the X-direction, similarly to the gate electrodes 230. The interlayer insulating layers 220 may be disposed between sacrificial insulating layers 218 by extending to the edge region EA, and may be included in a mold structure. The interlayer insulating layers 220 may include an insulating material such as, but not limited to, silicon oxide (SiO₂) or silicon nitride (Si₃N₄).

In example embodiments, thicknesses of the interlayer insulating layers 220 may not all be the same. For example, an uppermost interlayer insulating layer 223, a lowermost interlayer insulating layer 222, and an intermediate interlayer insulating layer 225, among the interlayer insulating layers 220, may have a greater thickness than the other interlayer insulating layers 220. However, the present disclosure is not limited thereto. The intermediate interlayer insulating layer 225 may be referred to as interlayer insulating layers between the first and second stack structures GS1 and GS2.

The separation regions MS may be disposed to extend in the X-direction by penetrating through the gate electrodes 230, as described above. The separation regions MS may be disposed to be parallel to each other and may be spaced apart from each other in the Y-direction. The separation regions MS may entirely penetrate through stacked gate electrodes 230 and may be connected to the upper capping layer 290. The separation regions MS may extend as one in the X-direction, but may extend intermittently in some regions or may be disposed only in some regions.

A separation insulating layer 264 may be disposed in the separation regions MS. The separation insulating layer 264 may have a shape in which a width thereof increases toward the first substrate 101 due to a high aspect ratio. However, the present disclosure is not limited thereto. A lower surface Sa of the separation insulating layer 264 may be in contact with the upper capping layer 290, and an upper surface thereof may be in contact with the lower surface of the first conductive layer 201. The separation insulating layer 264 may not extend to the edge region EA.

As illustrated in FIG. 2, the separation regions MS may be formed to have a flat side surface, but may have a structure in which a curved surface having a convex curvature toward the outside is continuously formed. The curved surface structure on the side surface may be derived by forming a plurality of separation holes separated from each other simultaneously (e.g., at a substantially similar and/or the same time) with forming the channel hole, and then, extending the plurality of separation holes to be connected to each other through a cleaning process and forming the separation regions MS.

The insulating regions SS may extend in the X-direction between the separation regions MS adjacent to each other. The insulating regions SS may be disposed in a portion of the second region R2 and in the first region R1. The insulating regions SS may penetrate through the upper gate electrode 230U disposed in an uppermost end, among the gate electrodes 230. As illustrated in FIG. 2, the insulating regions SS may divide the upper gate electrode 230U in the Y-direction. However, the number of gate electrodes 130U separated by the insulating regions SS may be variously changed in example embodiments.

The insulating regions SS may be disposed across a portion of the channel structures CH. The insulating regions SS have a predetermined width in the Y-direction, and may extend by intersecting a space between the plurality of channel structures CH arranged in a zigzag shape in the X-direction. Accordingly, when the plurality of channel structures CH are arranged to have the same separation distance, the insulating regions SS may extend by intersecting a row of channel structures CH at the same time. The insulating regions SS may be recessed into a portion of the channel structure CH facing upper portions of the channel structures CH (e.g., one gate electrode 130U), and consequently, a portion of the channel structures CH may be removed. In such a case, the channel structures CH may be recessed by a length less than a radius of the channel structure CH from a channel center axis to an inner wall of the channel hole. Accordingly, the insulating regions SS may not pass through the channel center axis of the channel structure CH and may be disposed so that at least half of the channel structure CH remains on an upper surface thereof. However, the present disclosure is not limited thereto. The channel structures CH into which the insulating regions SS are recessed may be effective channel structures actually functioning as memory cells, not dummy channel structures. Each of the insulating regions SS may include an upper separation insulating layer 268. The upper separation insulating layer 268 may include, but not be limited to, an insulating material, for example, silicon oxide (SiO₂), silicon nitride (Si₃N₄), or silicon oxynitride (SiON).

The channel structures CH may be spaced apart from each other by forming rows and/or columns on the lower surface of the first conductive layer 201 of the first region R1. The channel structures CH may be arranged in a zigzag shape in one direction in an X-Y plane. The channel structures CH may penetrate through the gate electrodes 230 and may extend in a vertical direction, perpendicular to the lower surface of the first conductive layer 201 (e.g., in the Z-direction), and may have a pillar shape and may have an inclined side surface in which a width thereof becomes narrower as the channel structures CH move closer to the first conductive layer 201 depending on the aspect ratio.

Each of the channel structures CH may have a form in which a first channel structure CH1 and a second channel structure CH2 respectively penetrating through a lower stack structure GS1 and an upper stack structure GS2 of the gate electrodes 230 are connected to each other, and may have a bent portion due to a difference or a change in width in the connection region.

As illustrated in the enlarged view of FIG. 4A, each of the channel structures CH may include a first portion within the first and second stack structures GS1 and GS2 and a second portion protruding above the first and second stack structures GS1 and GS2.

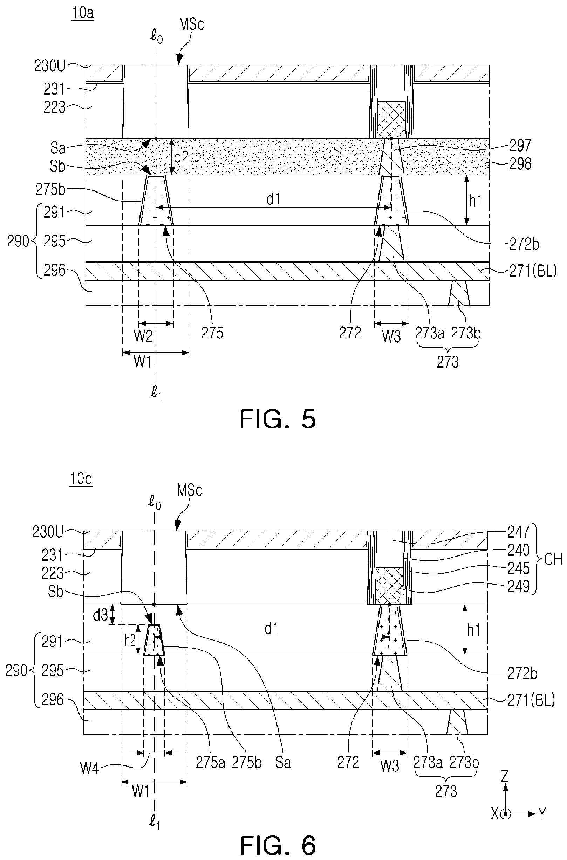

A channel layer 240 may be entirely disposed in the first portion and the second portion of the channel structure CH, and may be disposed up to an upper end of the second portion. The channel layer 240 may include a protrusion portion 240a disposed in the second portion of the channel structure CH, and protruding and exposed above the first and second stack structures GS1 and GS2, and a non-protrusion portion 240b disposed on the first portion of the channel structure CH. A length h1 of the second portions of the channel structures CH, that is a length h1 in which the protrusion portions 240a of the channel layer 240 protrude, may not be the same as each other. However, the present disclosure is not limited thereto. The channel layer 240 may be formed in an annular shape in which a side surface thereof surrounds an internal buried insulating layer 247, but may also have a columnar shape such as a cylindrical or angular column without the buried insulating layer 247, according to an example embodiment. The protrusion portion 240a of the channel layer 240 may be covered with the first conductive layer 201 and may be in direct contact with the first conductive layer 201. The protrusion portion 240a may be formed to have a gentle slope with the non-protrusion portion240b so that the annular shape is maintained as illustrated in FIG. 5A. The channel layer 240 may include a semiconductor material such as, but not limited to, polycrystalline silicon or single-crystal silicon, and the semiconductor material may be an undoped material or a material including P-type or N-type impurities.

In the channel structures CH, channel pads 249 may be disposed in a lower portion of the channel layer 240. The channel pads 249 may be disposed to cover a lower surface of the buried insulating layer 247 and may be electrically connected to the channel layer 240. The channel pads 249 may include, for example, doped polycrystalline silicon.

An information storage structure 245 may be disposed between the gate electrodes 230 and the channel layer 240. The information storage structure 245 may include a tunneling layer 241, a charge storage layer 242, and a blocking layer 243, sequentially stacked from a channel layer 240. The tunneling layer 241 may tunnel charges into the charge storage layer 242, and may include, for example, silicon oxide (SiO₂), silicon nitride (Si₃N₄), silicon oxynitride (SiON), or combinations thereof. The charge storage layer 242 may be a charge trapping layer or a floating gate conductive layer. The blocking layer 243 may include silicon oxide (SiO₂), silicon nitride (Si₃N₄), silicon oxynitride (SiON), a high-κ dielectric material, or combinations thereof. According to example embodiments, at least a portion of the information storage structure 245 may be included in a channel dielectric layer extending horizontally along the gate electrodes 230.

The information storage structure 245 may be removed from upper portions of the first and second stack structures GS 1 and GS2 so that the protrusion portion 240a of the channel layer 240 may be exposed to the outside in the second portion. Accordingly, an upper end of the information storage structure 245 may be in contact with the first conductive layer 201, and a side surface of the information storage structure 245 in the first portion may be disposed to surround the non-protrusion portion240b of the channel layer 240.

The channel layer 240, the information storage structure 245, and the buried insulating layer 247 may be connected to each other between the second channel structure CH2 and the first channel structure CH1. As described above, a relatively thick intermediate interlayer insulating layer 225 may be disposed between the second channel structure CH2 and the first channel structure CH1.

External contact vias may be connected to transmit an external signal to the first semiconductor structure S1 through a pad region 258 exposed to the outside and the upper interconnection structures 271 to 274 of the second semiconductor structure S2, in the edge region EA.

In the first region R1, the semiconductor device 10 may include a first conductive layer 201 between a lower surface of the second conductive layer 202 and the first and second stack structures GS1 and GS2. The first conductive layer 201 may include a semiconductor material. For example, the first conductive layer 201 may include a semiconductor material, such as, but not limited to, a group IV semiconductor, a group III-V compound semiconductor, or a group II-VI compound semiconductor. For example, the group IV semiconductor may include silicon (Si), germanium (Ge), or silicon-germanium (SiGe). The first conductive layer 201 may function as a common source line CSL of the semiconductor device 10. The first conductive layer 201 may include a silicon layer, for example, a silicon layer having an N-type conductivity type. For example, the first conductive layer 201 may be provided as a crystalline semiconductor layer or an epitaxial layer, such as, but not limited to, a single-crystal silicon layer or a polycrystalline silicon layer doped with an impurity. As illustrated in the enlarged view of FIG. 4A, the first conductive layer 201 may cover the second portion of the channel structure CH and may be in direct contact with the protrusion portion 240a of the channel layer 240.

The first conductive layer 201 may be and/or may include a plate layer entirely covering the first and second stack structures GS1 and GS2 and may be disposed to have a flat upper surface. The first conductive layer 201 may have a thickness greater than a length of the protrusion portion 240a of the channel layer 240, and may be conformally formed according to a shape of the channel structure CH.

The second conductive layer 202 may be disposed along the first conductive layer 201. The second conductive layer 202 may have a thickness thinner than a thickness of the first conductive layer 201, and may be a conductive layer in contact with the first conductive layer 201. The second conductive layer 202 may include, but not be limited to, at least one of a metal-semiconductor compound, a metal-nitride, or a metal (e.g., tungsten (W), copper (Cu), and aluminum (Al)). The second conductive layer 202 may be aligned vertically with the first conductive layer 201.

The first and second conductive layers 201 and 202 may serve as source layers and may be included in a source structure together. The source structure may function as a common source line CSL of the semiconductor device 10.

In some embodiments, the buffer layer may be further formed on the second conductive layer 202. The buffer layer may be an oxide conformally covering the second conductive layer 202 and may include, but not be limited to, silicon oxide (SiO₂), silicon nitride (Si₃N₄), or the like.

The upper interconnection structures 271 to 274 may electrically connect the gate electrodes 230 and the channel structures CH to the circuit elements 120 within the upper capping layer 290. The upper interconnection structures 271 to 274 may be connected to the channel studs 272 connected to the channel structures CH. The channel studs 272 disposed below the channel structure CH may be connected to the channel pads 249 of the channel structure CH. The channel studs 272 connected to the channel structure CH may be electrically connected to the channel layer 240 through the channel pads 249 of the channel structures CH in the first region R1. In the second region R2, studs may be connected to contact plugs connected to the gate electrode 230. The channel studs 272 may include a conductive material, and may include, for example, tungsten (W), copper (Cu), and aluminum (Al), and the channel studs 272 may further include a diffusion barrier 272b including at least one of titanium (Ti), titanium nitride (TiN), tantalum (Ta), tantalum nitride (TaN), or tungsten nitride (WN). However, the present disclosure is not limited in this regard.

A first upper interconnection line 271 may be electrically connected to the channel studs 272, and may include a plurality of bit lines BL extending in the Y-direction and spaced apart from each other with a predetermined pitch in the X-direction. A second upper interconnection line 274 may be disposed below the first upper interconnection line 271, and connecting vias 273 may be disposed between the second upper interconnection line 274 and the first upper interconnection line 271 and between the channel studs 272 and the first upper interconnection line 271. The upper interconnection structures 271 to 274 may also include a conductive material, and may include, for example, tungsten (W), copper (Cu), and aluminum (Al), and each of the components may further include a diffusion barrier including at least one of titanium (Ti), titanium nitride (TiN), tantalum (Ta), tantalum nitride (TaN), or tungsten nitride (WN). However, the present disclosure is not limited in this regard. According to example embodiments, the number of layers of the upper interconnection lines 271 and 274 included in the upper interconnection structures 271 to 274 and arrangement patterns thereof may be variously changed.

The address studs 275 may be disposed by corresponding to the address separation regions MSc among the separation regions MS and may be disposed below a lower surface Sa of the address separation regions MSc.

Each of the address studs 275 may include an upper surface Sb and a lower surface, and a side surface between the upper surface Sb and the lower surface. Each of the address studs 275 may have a width of the upper surface Sb less than a width of a lower surface W2, and may have a width increasing toward the lower surface. The side surface may have an inclination due to a difference in the width of the upper surface Sb and the lower surface. However, the present disclosure is not limited thereto. The size and shape of each of the address studs 275 may be substantially similar and/or the same as the size and shape of the channel studs 272. The channel studs 272 may also include an upper surface, a lower surface, and a side surface between the upper surface and the lower surface. Each of the channel studs 272 may have a width of the upper surface less than a width of a lower surface W3, and may have a width increasing toward the lower surface. The side surface may have an inclination due to the difference in the width of the upper surface and the lower surface. However, the present disclosure is not limited thereto. That is, when a width W2 of a lower surface of each of the address studs 275 is the greatest (e.g., widest), a width W3 of a lower surface of the channel studs 272 may also be the greatest, and the width W2 of the lower surface of the address studs 275 and the width W3 of the lower surface of the channel studs 272 may be substantially similar and/or the same. A length h1 of each of the address studs 275 (e.g., a length h1 in the Z-direction) may be substantially similar and/or the same as that of the channel studs 272, and may be greater than a length of the connecting vias 273 in the Z-direction. The lower surface of the address studs 275 and the lower surface of the channel studs 272 may be disposed on a substantially similar and/or the same level. A distance between the address studs 275 and the closest channel studs 272, among the channel studs 272, may satisfy a minimum distance d1 or more. The minimum distance d1 may be greater than a distance between the channel studs 272.

The upper capping layer 290 may include a plurality of capping insulating layers, and may include a first capping insulating layer 291, a second capping insulating layer 295, and a third capping insulating layer 296. However, the present disclosure is not limited thereto.

A structure of the first to third capping insulating layers 291 to 296 may denote that the first to third capping insulating layers 291 to 296 are stacked in different orders in the process, and the first to third capping insulating layers 291 to 296 may include a substantially similar and/or the same material. For example, the first to third capping insulating layers 291 to 296 may include, but not limited to, at least one of silicon carbonitride (SiCN), silicon oxide (SiO₂), silicon nitride (Si₃N₄), silicon oxycarbide (SiOC), silicon oxynitride (SiON), or silicon oxycarbonitride (SiOCN).

The separation regions MS may have a width W1 of a lower surface Sa, which may be greater than a width of an upper surface thereof, and the lower surface Sa of the separation regions MS may have a first width W1 in the Y-direction. The lower surface Sa of the address separation regions MSc and a lower surface of the channel structures CH may be substantially coplanar with a lower surface of the uppermost interlayer insulating layer 223.

The first capping insulating layer 291 may cover the lower surface Sa of the address separation regions MSc and the lower surface of the channel structures CH. The address studs 275 and the channel studs 272 may be disposed to penetrate through the first capping insulating layer 291. An upper surface Sb of the address studs 275 may be in contact with the lower surface Sa of the address separation regions MSc. However, the present disclosure is not limited thereto, and the address studs 275 may be disposed within the first capping insulating layer 291.

When a center line of the width W1 of the lower surface Sa of the address separation regions MSc in the Y-direction is referred to as a reference line ℓ₀ (which may be an example of the second reference line in the claims), if the center line of the width of the upper surface Sb of the address studs 275 in a lower portion thereof is referred to as a first line *ℓ*₁ (which may be an example of the first reference line in the claims), the reference line ℓ₀ and the first line *ℓ*₁ may be arranged to be coaxial. Accordingly, the address studs 275 may be disposed to be aligned in the Z-direction so as to be disposed in the center on the lower surface Sa of the address separation regions MSc.

The second capping insulating layer 295 may be disposed below the first capping insulating layer 291. First upper vias 273a penetrating through the second capping insulating layer 295, among the connecting vias 273, may be disposed. The first upper vias 273a may not be connected to the address studs 275 but may be connected to the channel studs 272.

The first upper vias 273a may be connected to the first interconnection lines 271. The first upper vias 273a may be connected to the first interconnection lines 271, for example, the bit lines BL, to apply an electrical signal to the channel structures CH. The address studs 275 may be spaced apart from the first interconnection lines 271 including the bit lines BL in the Z-direction. The second capping insulating layer 295 may be disposed between the address studs 275 and the first interconnection lines 271 including the bit lines BL.

A third capping insulating layer 296 may be disposed on the second capping insulating layer 295, and second upper vias 273b and the second interconnection lines 274 may be disposed within the third capping insulating layer 296 and may be connected to the first interconnection lines 271.

The upper bonding structure 280 may be connected to the upper interconnection structures 271 to 274. For example, the channel studs 272 may be electrically connected to the upper bonding structure 280. The upper bonding structure 280 may include an upper bonding via 282, an upper bonding pad 284, and an upper bonding insulating layer 286. The upper bonding via 282 may be connected to an upper interconnection structure 271 to 274. The upper bonding pad 284 may be connected to the upper bonding via 282. The upper bonding via 282 and the upper bonding pad 284 may include a conductive material, and may include, for example, tungsten (W), copper (Cu), and aluminum (Al), and each of the components may further include a diffusion barrier. The upper bonding insulating layer 286 may also function as a diffusion barrier of the upper bonding pad 284, and may include at least one of silicon carbonitride (SiCN), silicon oxide (SiO₂), silicon nitride (Si₃N₄), silicon oxycarbide (SiOC), silicon oxynitride (SiON), or silicon oxycarbonitride (SiOCN). The upper bonding insulating layer 286 may have a thickness thinner than a thickness of the upper bonding pad 284. However, the present disclosure is not limited thereto.

Hereinafter, example embodiments of the present disclosure are described with reference to FIGS. 5 to 13. FIGS. 5 to 7 are enlarged views of a semiconductor device, according to example embodiments, and are enlarged views of regions corresponding to FIG. 4B.

Referring to FIG. 5, a semiconductor device 10a may include and/or may be similar in many respects to the semiconductor device 10 described above with reference to FIG. 4B, and may include additional features not mentioned above. For example, the semiconductor device 10a may further include a base layer 298. Consequently, repeated descriptions of the semiconductor device 10a described above with reference to FIG. 4B may be omitted for the sake of brevity.

That is, the semiconductor device 10a may further include the base layer 298 on the lower surface Sa of the channel structures CH and the separation regions MS. The base layer 298 may include a different insulating material from the upper capping layer 290, for example, when the upper capping layer 290 includes silicon oxide (SiO₂), the base layer 298 may include a material such as, but not limited to, silicon nitride (Si₃N₄). The base layer 298 is an etch-stop layer, and may be used to prevent a via hole from being formed from the lower surface Sa of the address separation regions MSc to the inside thereof when forming the address studs 275. Depending on the size of the separation regions MS, some metal materials may remain in the separation regions MS after a substitution process of the gate electrodes 230. When forming the via hole for forming the address studs 275, if the address studs 275 are etched to the inside of the separation regions MS, the address studs 275 may be formed to extend to the inside of the separation regions MS, thus forming a parasitic capacitance, and a short circuit may occur between the gate electrodes 230 of neighboring memory blocks BLK.

Accordingly, in order to prevent the via hole from being formed inside the separation regions MS when forming the via hole, a capping insulating layer 290 and a base layer 298 having etching selectivity may be further formed, and thus, when forming the via hole for the address studs 275, the via hole may be formed only to a lower surface of the base layer 298, thereby protecting the address separation regions MSc in an upper portion.

Accordingly, a first capping insulating layer 291 may be disposed on the lower surface of the base layer 298, and studs (e.g., address studs 275 and channel studs 272) penetrating through the first capping insulating layer 291 may be disposed. In an embodiment, third upper vias 297 may be further disposed for electrical connection between the channel structures CH and the channel studs 272. The third upper vias 297 may include a conductive material, and may include the same material as the first and second upper vias 273a and 273b, and may have a smaller area and length than those of the channel studs 272. The third upper vias 297 may have a length equal to a thickness of the base layer 298.

In such a manner, the base layer 298 may be disposed between the upper surface Sb of the address studs 275 and the lower surface Sa of the address separation regions MSc, and the address separation regions MSc and the address studs 275 may be physically separated from each other by a second distance d2.

Referring to FIG. 6, a semiconductor device 10b may include and/or may be similar in many respects to the semiconductor device 10 described above with reference to FIG. 4B, and may include additional features not mentioned above. For example, the size of the address studs 275 may differ. Consequently, repeated descriptions of the semiconductor device 10b described above with reference to FIG. 4B may be omitted for the sake of brevity.

Each of the address studs 275 may include an upper surface Sb and a lower surface and a side surface between the upper surface Sb and the lower surface. Each of the address studs 275 may have a width of the upper surface Sb less than a width of a lower surface W4, and may have a width increasing toward the lower surface. The side surface may have an inclination due to the difference in the width of the upper surface Sb and the lower surface. However, the present disclosure is not limited thereto. The size and shape of each of the address studs 275 may be different from the size and shape of the channel studs 272. The channel studs 272 may also include a side surface between the upper surface and the lower surface and the upper surface and the lower surface. Each of the channel studs 272 may have a width of the upper surface less than a width of the lower surface, and may have a width increasing toward the lower surface. The side surface may have an inclination due to the difference in the width between the upper surface and the lower surface. However, the present disclosure is not limited thereto. That is, when a width W4 of the lower surface of each address stud 275 is the greatest (e.g., widest), a width W3 of the lower surface of the channel studs 272 may also be the greatest, and a width W4 of the lower surface of the address studs 275 may be less than the width W3 of the lower surface of the channel studs 272. A width of the upper surface Sb of the address studs 275 may be less than a width of the upper surface of the channel studs 272, and a length h2 of the address studs 275 (e.g., the length h2 in the Z-direction) may be less than a length h1 of the channel studs 272, but may be larger than the length of the upper vias 273.

Accordingly, the address studs 275 may be disposed in the first capping insulating layer 291, and a lower surface of the address studs 275 may be coplanar with the lower surface of the channel studs 272, and may be coplanar with the lower surface of the first capping insulating layer 291. However, the upper surface Sb of the address studs 275 may be physically spaced apart from the lower surface Sa of the address separation region MSc by a third distance d3 in the Z-direction, and a portion of the first capping insulating layer 291 may be disposed in a separation space.

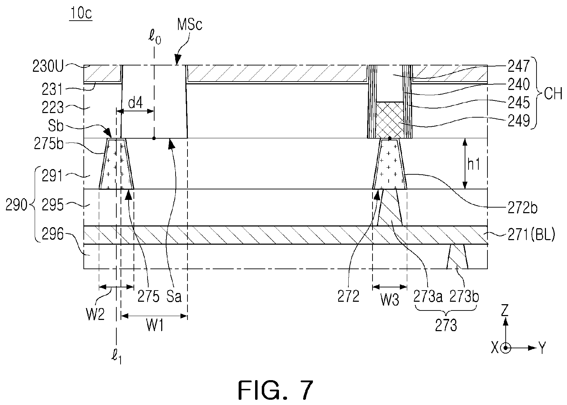

Referring to FIG. 7, a semiconductor device 10c may include and/or may be similar in many respects to the semiconductor device 10 described above with reference to FIG. 4B, and may include additional features not mentioned above. For example, the alignment of the address studs 275 may differ. Consequently, repeated descriptions of the semiconductor device 10c described above with reference to FIG. 4B may be omitted for the sake of brevity.

The first capping insulating layer 291 may be disposed to cover the lower surface of the separation regions MS and the channel structures CH. Address studs 275 and channel studs 272 may be disposed by penetrating through the first capping insulating layer 291. The upper surface Sb of the address studs 275 may be contact with the upper surface Sa of the address separation regions MSc. However, the present disclosure is not limited thereto, and the address studs 275 may be disposed within the first capping insulating layer 291.

When a center line of the width W1 of the lower surface Sa of the address separation regions MSc is referred to as a reference line ℓ₀ (which may be an example of the second reference line in the claims), if the center line of the width of the upper surface Sb of the address studs 275 in a lower portion thereof is referred to as a first line ℓ₁(which may be an example of the first reference line in the claims), the address studs 275 may be disposed so that the first line ℓ₁ is offset from the reference line ℓ₀ by a fourth distance d4. Accordingly, the address studs 275 may be disposed so as to be offset from a center thereof and approach one side thereof, below the lower surface Sa of the address separation regions MSc. At least a portion of the upper surface Sb of the address studs 275 may be in contact with the uppermost interlayer insulating layer 223. However, the present disclosure is not limited thereto.

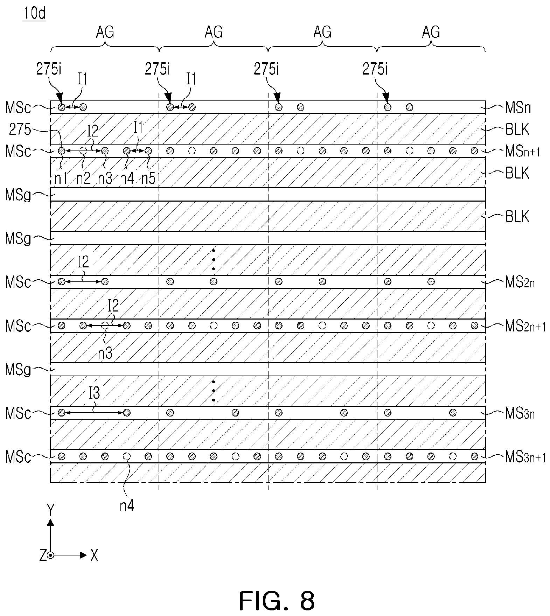

A semiconductor device 10d of FIG. 8 may include and/or may be similar in many respects to the semiconductor device 10 described above with reference to FIGS. 1 to 4B, and may include additional features not mentioned above. For example, the array rule of the address studs 275 may differ. Consequently, repeated descriptions of the semiconductor device 10d described above with reference to FIGS. 1 to 4B may be omitted for the sake of brevity.

Referring to FIG. 8, the separation regions MS in which the address studs 275 are disposed may be referred to as the address separation regions MSc. The address separation regions MSc may be disposed in every n-th separation region MS in the Y-direction. The address separation regions MSc may be arranged in pairs. That is, adjacent separation regions MS disposed above and below a memory block BLK may be a pair of address separation regions MSc. For example, when n is 50 (e.g., n = 50), n-th (e.g., 50th) and (n+1)-th (e.g., 51st) separation regions MS may form a pair of address separation regions MSc, (2n)-th (e.g., 100th) and (2n+1)-th (e.g., 101st) separation regions MS may form another pair of address separation regions MSc, and the (3n)-th (e.g., 150th) and (3n+1)-th (e.g., 151st) separation regions MS may form another pair of address separation regions MSc. That is, array rules may be applied differently to multiple pairs of address separation regions MSc.

In a pair of address separation regions MSc, one row of address studs 275 may be spaced apart from each other in the X-direction on each address separation region MSc. Two rows of address studs 275 on a pair of address separation regions MSc may form an array group AG disposed according to an array rule, and as illustrated in FIG. 1 and FIG. 2, the array rule may determine that the address studs 275 are selectively positioned for stud positions n1 to n5 in the X-direction.

For example, when there are five (5) stud positions (e.g., first to fifth stud positions n1 to n5) in each row in one array group AG, the address studs 275 on address separation regions MSc (e.g., MSn and MSn+1) forming a first pair may set an array rule in which a start address studs 275i are disposed in a first stud position n1 of a first row and a second row, and an address stud 275 of a second stud position n2 is located in the first row. Accordingly, the first separation distance I1 may be satisfied between the start address stud 275i of the first row and the adjacent address stud 275.

The address studs 275 on address separation regions MSc (e.g., MS2n and MS2n+1) forming a second pair may set an array rule in which the start address studs 275i are disposed in the first stud position n1 of the first and second rows, and an address stud 275 of a third stud position n3 is located in the first row. Accordingly, the second separation distance I2 (e.g., twice the first separation distance I1, I2 = 2 × I1) may be satisfied between the start address stud 275i of the first row and an adjacent address stud 275.

The address studs 275 on address separation regions MSc (e.g., MS3n and MS3n+1) forming a third pair may set an array rule in which the start address studs 275i are disposed in the first stud position n1 of the first row and the second row, and an address stud 275 of a fourth stud position n4 is located in the first row. Accordingly, the third separation distance I3 (e.g., three times the first separation distance I1, I3 = 3 × I1) may be satisfied between the start address stud 275i of the first row and the adjacent address stud 275.

In such a manner, by setting the array rule of the array group AG differently according to the position of the address separation regions MSc, during error inspection, the arrangement of the address studs 275 may be confirmed, and thus, a position in the Y-direction, as well as a position in the X-direction (e.g., a location of the memory block BLK) may be quickly confirmed.

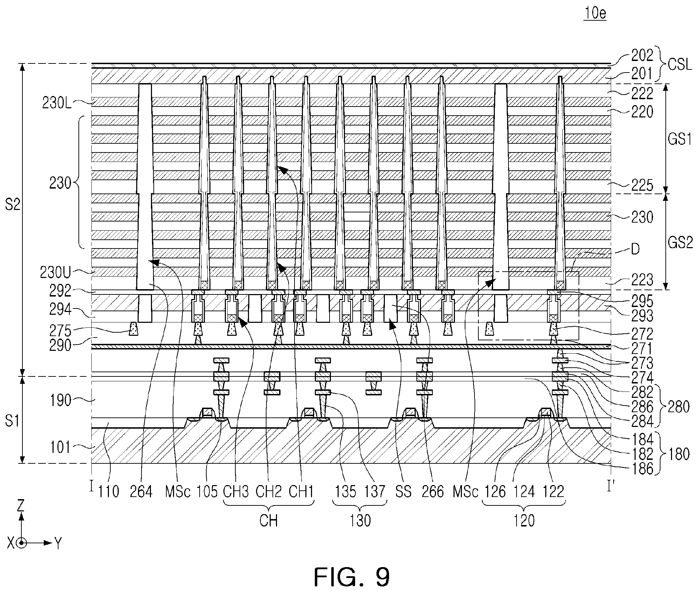

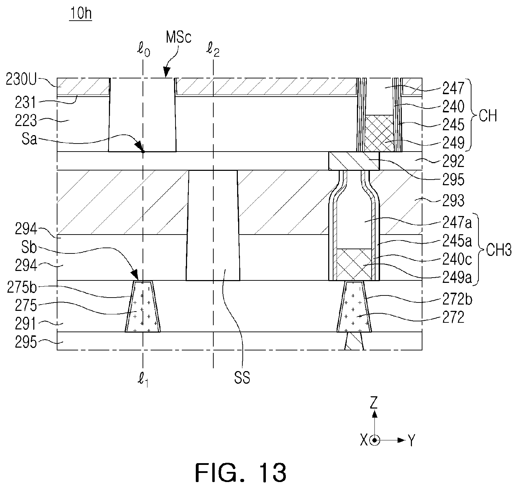

Referring to FIGS. 9 and 13, various semiconductor devices are described.

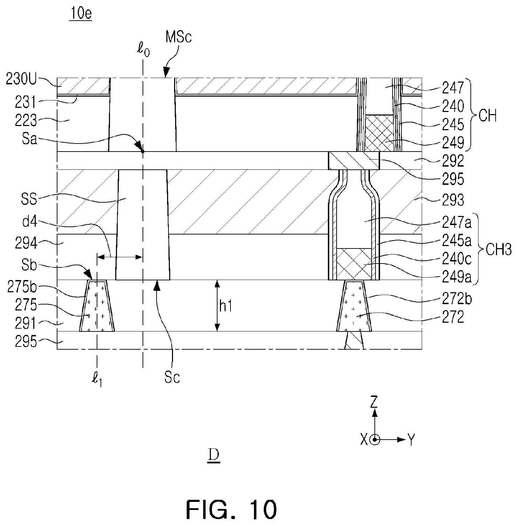

FIG. 9 is a cross-sectional view of a semiconductor device, according to example embodiments. FIG. 10 is an enlarged cross-sectional view of region D of FIG. 9, according to example embodiments.

Referring to FIGS. 9 and 10, a semiconductor device 10e may include and/or may be similar in many respects to the semiconductor device 10 described above with reference to FIGS. 3 to 4B, and may include additional features not mentioned above. For example, an upper channel structure CH3 may be disposed on first and second channel structures CH1 and CH2 and is included in one channel structure CH. Consequently, repeated descriptions of the semiconductor device 10e described above with reference to FIGS. 3 to 4B may be omitted for the sake of brevity.

The upper channel structures CH3 may extend in the Z-direction through an upper gate electrode 293 and may be connected to the first and second channel structures CH1 and CH2, respectively. The upper channel structures CH3 may be disposed on the first and second channel structures CH1 and CH2, respectively, and may be disposed to be shifted in the horizontal direction from the first and second channel structures CH1 and CH2. However, the present disclosure is not limited thereto.

As illustrated in FIGS. 9 and 10, each of the upper channel structures CH3 may include an upper channel layer 240c, an upper gate dielectric layer 245a, an upper channel buried insulating layer 247a, and an upper channel pad 249a disposed within an upper channel hole. The upper channel layer 240c may be formed in an annular shape surrounding the upper channel buried insulating layer 247a therein. The upper channel layer 240c may be connected to a connection pad 295 in an upper portion thereof, and may be electrically connected to the channel layers 240 of the first and second channel structures CH1 and CH2 in an upper portion thereof through the connection pad 295.

The description of the lower channel layer 240, the information storage structure 245, the channel buried insulating layer 247, and the channel pad layer 249 described above may be equally applied to the description of the materials of the upper channel layer 240c, the upper gate dielectric layer 245a, the upper channel buried insulating layer 247a, and the upper channel pad 249a.

A horizontal insulating layer 292 may be disposed between the upper first and second channel structures CH1 and CH2 and the upper channel structures CH3 and may extend horizontally. The horizontal insulating layer 292 may be disposed between the upper gate electrode 293 and the uppermost interlayer insulating layer 223. The horizontal insulating layer 292 may be used as an etch stop layer when forming the upper channel structures CH3 and may also be used when forming the connection pads 295.

The horizontal insulating layer 292 may include an insulating material and may include a different material from the uppermost interlayer insulating layer 223. The horizontal insulating layer 292 may be a hydrogen blocking layer and may include a material blocking or reducing diffusion of hydrogen (H). The horizontal insulating layer 292 may include a nitride, and may include, for example, at least one of silicon nitride (Si₃N₄), silicon oxynitride (SiON), silicon carbonitride (SiCN), or silicon oxycarbonitride (SiOCN).

The connection pads 295 may penetrate through the horizontal insulating layer 292 between the upper first and second channel structures CH1 and CH2 and the upper channel structures CH3, and may electrically connect the lower channel layers 240 and the upper channel layers 240c. The connection pads 295 may be formed by removing a portion of the horizontal insulating layer 292, and may thus have upper surfaces that are coplanar with an upper surface of the horizontal insulating layer 292. The connection pads 295 may be disposed in a form in which the upper channel pad layer 249 is partially recessed. However, a specific arrangement form of the connection pads 295 may be variously changed in example embodiments. The connection pads 295 may include a conductive material, and may include, for example, polycrystalline silicon. However, the present disclosure is not limited in this regard.

The upper gate electrode 293 may be disposed on an X-Y plane and may include a conductive material. The upper gate electrode 293 may include a substantially similar and/or the same material as the gate electrodes 230, but may include doped polysilicon.

The insulating regions SS may extend in the X-direction between the adjacent separation regions MS. The insulating regions SS may penetrate through the upper gate electrode 293 disposed in an uppermost portion of the gate electrodes 230. The insulating regions SS may divide the upper gate electrode 293 in the Y-direction. Some of the insulating regions SS may be disposed on the separation regions MS. Accordingly, the insulating regions SS may be disposed to separate only the upper gate electrode 293, rather than being formed by recessing some of the channel structures CH as in FIG. 3.

Each of the insulating regions SS may include an upper separation insulating layer 266. The upper separation insulating layer 266 may include an insulating material, and may include, for example, silicon oxide (SiO₂), silicon nitride (Si₃N₄), or silicon oxynitride (SiON). However, the present disclosure is not limited in this regard.

A second horizontal insulating layer 294 may be disposed to cover the upper gate electrode 293. The second horizontal insulating layer 294 may be disposed on the horizontal insulating layer 292 and may cover an upper surface and a side surface of the upper gate electrode 293. The first capping insulating layer 291 may be disposed below the second horizontal insulating layer 294, and the first capping insulating layer 291 and the second horizontal insulating layer 294 may be formed of an insulating material and may be formed of a plurality of insulating layers.

The channel studs 272 and the address studs 275 may be disposed through the first capping insulating layer 291. The address studs 275 may be disposed below the address separation regions MSc, and the channel studs 272 may be disposed below the upper channel pads 249a of the upper channel structure CH3. The shape and arrangement of the channel studs 272 may be substantially similar and/or the same as those of FIG. 4B, except that the channel pad 249 may be changed to the upper channel pad 249a.

The shape of the address studs 275 may be substantially similar and/or the same as the shape of the address studs 275 of FIG. 4B. When a center line of a width of the address separation region MSc in the Y-direction is referred to as a reference line ℓ₀ (which may be an example of the second reference line in the claims), a center line of a width of the address studs 275 may be referred to as a first line ℓ₁ (which may be an example of the first reference line in the claims), and a center line of a width of the insulating region SS in the Y-direction may be referred to as a second line ℓ₂ (which may be an example of the third reference line in the claims).

As shown in FIG. 10, the reference line ℓ₀ (which may be an example of the second reference line in the claims) and the second line ℓ₂ (not shown in Fig. 10) may be coaxial and may be aligned in the Z-direction, and in this case, the first line ℓ₁ (which may be an example of the first reference line in the claims) may be offset from the reference line ℓ₀*.* It may be described that at least a portion of the upper surface Sb of the address studs 275 is not disposed on a lower surface Sc of the insulating region SS but is disposed on the upper horizontal insulation layer 294.

In an embodiment, the second horizontal insulating layer 294 may be disposed between the upper gate electrode 293 and the address stud 275, and the insulating region SS and the address stud 275 are offset, and thus, when forming a via hole for the address stud 275, it may be possible to prevent a short circuit from occurring with the upper gate electrode 293 by penetrating to the insulating region SS.

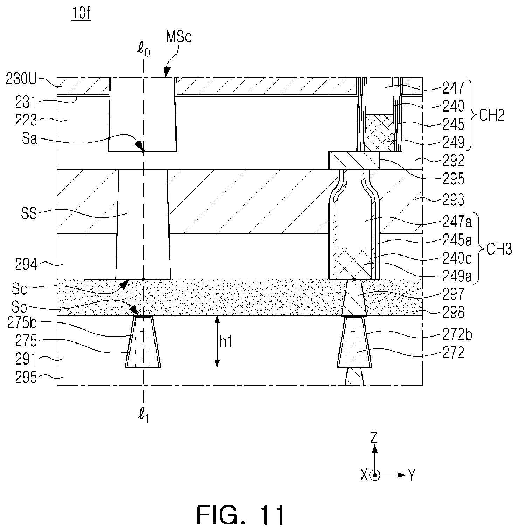

A semiconductor device 10f of FIG. 11 may include and/or may be similar in many respects to the semiconductor device 10e described above with reference to FIG. 10, and may include additional features not mentioned above. For example, the semiconductor device 10f may include a base layer 298. Consequently, repeated descriptions of the semiconductor device 10f described above with reference to FIG. 10 may be omitted for the sake of brevity.

That is, the semiconductor device 10f may further include a base layer 298 on the upper channel structures CH3 and the lower surface Sc of the insulating regions SS. When the base layer 298 includes a different insulating material from the upper capping layer 290, for example, when the upper capping layer 290 includes silicon oxide (SiO₂), the base layer 298 may include a material such as silicon nitride (Si₃N₄). The base layer 298 is an etch-stop layer, and when forming the address studs 275, the base layer 298 may prevent the address studs 275 from protruding inwardly from the lower surface Sc of the insulating regions SS.

In order to prevent the via hole from being formed inside the insulating regions SS when forming the via hole, the capping insulating layer 290 and the base layer 298 with etch selectivity may be further formed, and thus, when forming the via hole for the address studs 275, the via hole may be formed only to a lower surface of the base layer 298, thereby protecting the insulating regions SS in an upper portion thereof.

Accordingly, the first capping insulating layer 291 may be disposed on the lower surface of the base layer 298, and the address studs 275 penetrating through the first capping insulating layer 291 may be disposed. In an embodiment, third upper vias 297 may be further disposed for electrical connection between the upper channel structures CH3 and the channel studs 272. The third upper vias 297 may include a conductive material, may include a substantially similar and/or the same material as the first and second upper vias 293, and may have a smaller area and length than the studs 272 and 275. The third upper vias 297 may have a length equal to a thickness of the base layer 298.

By the base layer 298, the reference line ℓ₀ (which may be an example of the second reference line in the claims) and the first line ℓ₁ (which may be an example of the first reference line in the claims) and the second line ℓ₂ may be coaxial, and the address studs 275 and the insulating regions SS may be aligned in the Z-direction, but the base layer 298 may be disposed therebetween, and the insulating region SS and the address studs 275 may be physically separated from each other.

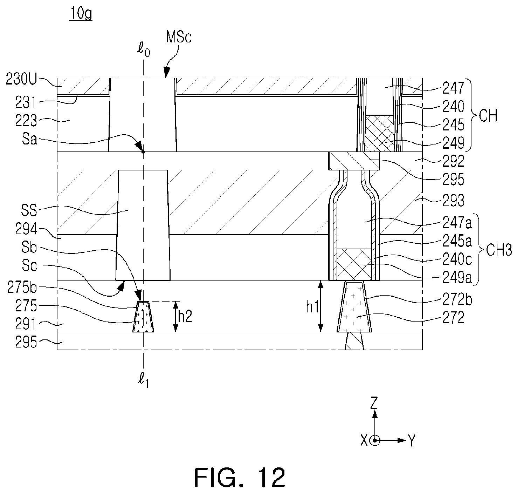

Referring to FIG. 12, a semiconductor device 10g may include and/or may be similar in many respects to the semiconductor device 10e described above with reference to FIG. 10, and may include additional features not mentioned above. For example, the size of the address studs 275 may differ. Consequently, repeated descriptions of the semiconductor device 10g described above with reference to FIG. 10 may be omitted for the sake of brevity.

Each address stud 275 may include an upper surface Sb and a lower surface, and a side surface between the upper surface and the lower surface. Each address stud 275 may have a width of the upper surface Sb less than a width of the lower surface, and may have a width increasing toward the lower surface. The side surface may have an inclination due to the difference in the width of the upper surface Sb and the lower surface. However, the present disclosure is not limited thereto. The size and shape of each address stud 275 may be different from the size and shape of the channel studs 272. The channel studs 272 may also include an upper surface and a lower surface, and a side surface between the upper surface and the lower surface. A width of the upper surface of each channel stud 272 may be less (e.g., narrower) than a width of the lower surface, and may have a width increasing toward the lower surface. The side surface may have an inclination due to the difference in the width of the upper surface and the lower surface. However, the present disclosure is not limited thereto. That is, when the width of the lower surface of each address stud 275 is the greatest (e.g., widest), a width of the lower surface of the channel studs 272 may also be the greatest, and a width of the lower surface of the address studs 275 may be less than the width of the lower surface of the channel studs 272. A width of the upper surface Sb of the address studs 275 may be less than a width of the upper surface of the channel studs 272, and a length h2 of the address studs 275 (e.g., the length h2 in the Z-direction) may be less than a length h1 of the channel studs 272, but may be greater than a length of the upper vias 273.

Accordingly, the address studs 275 may be disposed within the first capping insulating layer 291, and the lower surface of the address studs 275 may be coplanar with the lower surface of the channel studs 272 and coplanar with a lower surface of the first capping insulating layer 294. However, the upper surface Sb of the address studs 275 may be physically spaced apart from the lower surface of the insulating region SS in the Z-direction, and a portion of the first capping insulating layer 294 may be disposed in a separation space. By miniaturizing the address studs 275, the reference line ℓ₀ (which may be an example of the second reference line in the claims) and the first line ℓ₁ (which may be an example of the first reference line in the claims) and the second line ℓ₂ may be coaxial, and the insulating region SS and the address studs 275 may be physically separated.

Referring to FIG. 13, a semiconductor device 10h may include and/or may be similar in many respects to the semiconductor device 10e described above with reference to FIG. 10, and may include additional features not mentioned above. For example, the arrangement of the address studs 275 and the insulating region SS may differ. Consequently, repeated descriptions of the semiconductor device 10h described above with reference to FIG. 10 may be omitted for the sake of brevity.

The first line *ℓ*₁ (which may be an example of the first reference line in the claims) of the address studs 275 may be coaxial with the reference line ℓ₀ (which may be an example of the second reference line in the claims)of the address separation region MSc, and the second line ℓ₂ (which may be an example of the third reference line in the claims)of the insulating regions SS may be offset from the reference line ℓ₀ of the separation regions MS in the Z-direction.

That is, the insulating regions SS may be disposed so as to be offset to one side from a lower portion of the address separation regions MSc so as not to overlap each other in the Z-direction. Accordingly, even if the via hole of the address studs 275 penetrates through the upper horizontal insulating layer 294, the via hole may be in contact with the upper gate electrode 293, but may be physically and electrically separated from an adjacent upper gate electrode 293 by the insulating regions SS. Therefore, a short circuit between the upper gate electrodes 293 may be prevented by over-etching of the address studs 275.

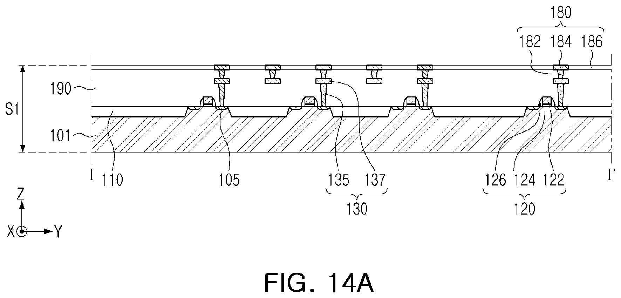

FIGS. 14A to 14G are schematic cross-sectional views illustrating a method of manufacturing a semiconductor device, according to example embodiments. FIGS. 14A to 14G illustrate regions corresponding to FIG. 3.

Referring to FIG. 14A, a first semiconductor structure S1 including circuit elements 120, a lower interconnection structure 130, a lower bonding structure 180, and a lower capping layer 190 included in a peripheral circuit region PERI may be formed on a first substrate 101.

In an embodiment, the device isolating layers 110 may be formed in the first substrate 101, and a circuit gate dielectric layer 122 and a circuit gate electrode 124 may be sequentially formed on the first substrate 101. The device isolation layers 110 may be formed, for example, by a shallow trench isolation (STI) process. The circuit gate dielectric layer 122 may be formed on the first substrate 101, and the circuit gate electrode 124 may be formed on the circuit gate dielectric layer 122. The circuit gate dielectric layer 122 and the circuit gate electrode 124 may be formed using atomic layer deposition (ALD) or chemical vapor deposition (CVD). The circuit gate dielectric layer 122 may be formed of silicon oxide (SiO₂), and the circuit gate electrode 124 may be formed of at least one of polycrystalline silicon or a metal silicide layer. However, the present disclosure is not limited thereto. Subsequently, spacer layers 126 may be formed on both sidewalls of the circuit gate dielectric layer 122 and the circuit gate electrode 124, and impurities may be injected into the active region of the first substrate 101 on both sides of the circuit gate electrode 124 to form source/drain regions 105.

The lower contact plugs 135 among the lower interconnection structures 130 may be formed by forming a portion of the lower capping layer 190, etching and removing a portion the lower capping layer 190, and filling the removed portion with a conductive material. The lower interconnection lines 137 may be formed, for example, by depositing a conductive material and patterning the conductive material.

The lower bonding vias 182 among the lower bonding structures 180 may be formed by forming a portion of the lower capping layer 190, etching and removing a portion of the lower capping layer 190, and filling the removed portion with a conductive material. The lower bonding pad 184 may be formed, for example, by depositing a conductive material and patterning the conductive material. The lower bonding structure 180 may be formed, for example, by a deposition process or a plating process. The lower bonding insulating layer 186 may be formed by covering a portion of an upper surface and a side surface of the lower bonding pad 184, and performing a planarization process until the upper surface of the lower bonding pad 184 is exposed.

The lower capping layer 190 may be formed of a plurality of insulating layers. The lower capping layer 190 may be and/or may include a portion of respective operations of forming the lower interconnection structure 130 and the lower bonding structure 180. Accordingly, the first semiconductor structure S1, which is a peripheral circuit area PERI, may be formed.

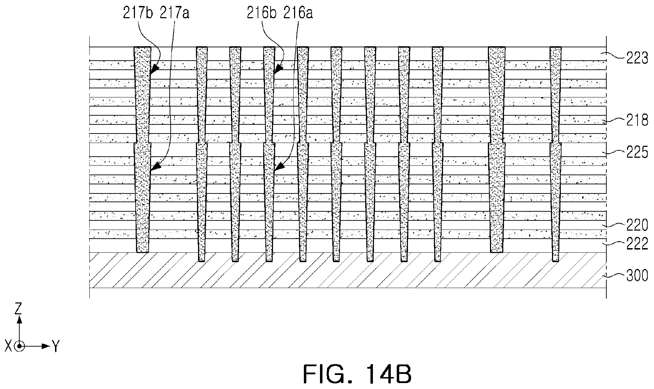

Referring to FIG. 14B, a manufacturing process of a second semiconductor structure S2 may begin. Sacrificial insulating layers 118 and interlayer insulating layers 220 may be alternately stacked on a base substrate 300 (SUB) to form a mold structure, and sacrificial vertical structures (e.g., first vertical sacrificial layers 216a, second vertical sacrificial layers 216b, first separation sacrificial layers 217a, and second separation sacrificial layers 217b) may be formed in positions in which each vertical structure is formed, respectively.

A lower mold structure may be formed on the base substrate 300 at a height at which the first channel structures CH1 are disposed. The base substrate 300 may include a semiconductor material, for example, a group IV semiconductor, a group III-V compound semiconductor, or a group II-VI compound semiconductor.

The sacrificial insulating layers 218 may be layers in which at least a portion thereof is replaced with a portion of the gate electrodes 230 through a subsequent process. The sacrificial insulating layers 218 may be formed of a different material from the interlayer insulating layers 220. For example, the interlayer insulating layer 220 and uppermost, intermediate, and lowermost interlayer insulating layers 222, 223 and 225 may be formed of at least one of silicon oxide (SiO₂) or silicon nitride (Si₃N₄), and the sacrificial insulating layers 218 may be formed of a different material from the interlayer insulating layer 220 selected from silicon (Si), silicon oxide (SiO₂), silicon carbide (SiC), and silicon nitride (Si₃N₄). In example embodiments, the thicknesses of the interlayer insulating layers 220 may not all be the same. Additionally, the thicknesses of the interlayer insulating layers 220 and the sacrificial insulating layers 218 and the number of films included therein may be variously changed from those illustrated.

The interlayer insulating layers 220 and the sacrificial insulating layers 218 included in the lower mold structure may be alternately stacked on the base substrate 300.

When forming a gate pad region in the second regions R2, a photolithography process and an etching process for the sacrificial insulating layers 218 and the interlayer insulating layers 220 may be performed repeatedly. However, in example embodiments, the specific shape of the gate pad region may be variously changed.

First vertical sacrificial layers 216a may be formed in a position corresponding to a lower portion of the first channel structures CH1 in the first region R1. The first vertical sacrificial layers 216a may be formed by forming holes to penetrate through a lower mold structure MS1, depositing a sacrificial layer material in the holes, and performing a planarization process. When forming the holes, a plurality of separation holes spaced apart from each other may be formed in a region corresponding to the separation region MS, and a first separation sacrificial layer 217a filling the plurality of separation holes may be formed together. The vertical sacrificial layers including the first vertical sacrificial layers 216a and the first separation sacrificial layers 217a may include, for example, at least one of titanium nitride (TiN) or polycrystalline silicon.

The sacrificial insulating layers 218 and the interlayer insulating layers 220 included in an upper mold structure may be alternately stacked on the lower mold structure, and second vertical sacrificial layers 216b and a second separation sacrificial layer 217b may be formed.

Each component of an upper mold structure MS2 may be formed in the same manner as a formation method of the lower mold structure MS1. The second vertical sacrificial layers 216b may be formed to be connected to the first vertical sacrificial layers 216a, respectively. The second separation sacrificial layers 217b may be formed to be connected to the first separation sacrificial layers 217a, respectively. The second vertical sacrificial layers 216b and the second separation sacrificial layers 217b may be formed by depositing a substantially similar and/or the same material as the first vertical sacrificial layers 216a (e.g., polycrystalline silicon). However, the present disclosure is not limited in this regard.

Accordingly, a plurality of sacrificial vertical sacrificial layers 216a to 217b included in all of the vertical structures of FIG. 3, channel structures CH and separation regions MS, may be formed simultaneously (e.g., at a substantially similar and/or the same time).

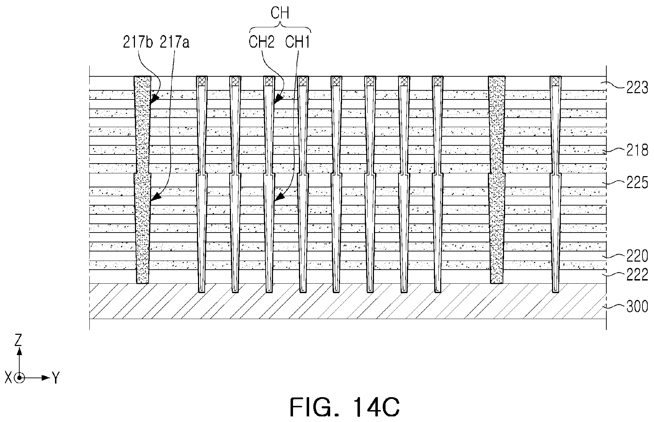

As illustrated in FIG. 14C, on the base substrate 300, channel structures CH penetrating through the mold structure of the sacrificial insulating layers 218 and the interlayer insulating layers 220 may be formed.

The channel structures CH may be formed by forming upper holes on vertical sacrificial layers 216a and 216b, then removing the vertical sacrificial layers 216a and 216b to form hole-shaped channel holes, and filling the channel holes with a plurality of layers. The plurality of layers may include an information storage structure 245, a channel layer 240, a buried insulating layer 247, and a channel pad 249. Upper channel holes of the channel holes may be formed by anisotropically etching the upper stack structure of the sacrificial insulating layers 218 and the interlayer insulating layers 220 using a separate mask layer. Lower channel holes of the channel holes may be formed by removing the vertical sacrificial layer exposed through the upper channel holes.

Due to a height of the mold structure, side walls of the channel structures CH may not be perpendicular to an upper surface of the base substrate 300. The channel structures CH may be formed to recess a portion of the base substrate 300 according to a depth of the channel hole.

The information storage structure 245 may be formed to have a uniform thickness. The information storage structure 245 may be formed in whole or in part in this operation, and a portion extending vertically along the channel structures CH to the base substrate 300 may be formed in this operation. The channel layer 240 may be formed on the information storage structure 245 within the channel structures CH. A buried insulating layer 247 may be formed to fill the channel structures CH and may be formed of an insulating material. The channel pad 249 may be formed of a conductive material, and may be formed of, for example, polycrystalline silicon. After the channel structure CH is formed, contact plugs may be formed in the second region R2.

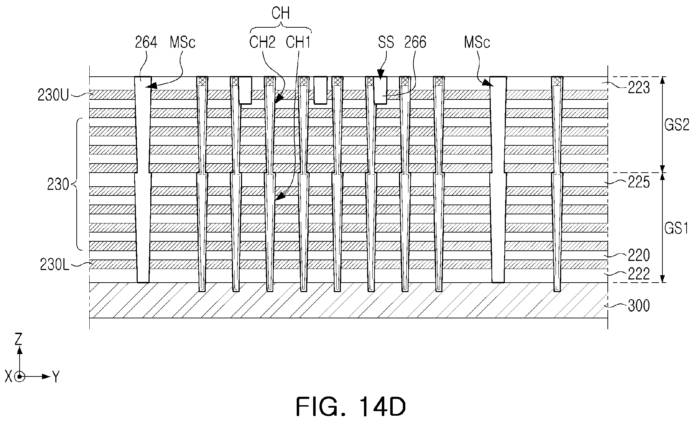

Referring to FIG. 14D, gate electrodes 230 may be formed. The separation sacrificial layers 217a and 217b filling separation holes formed in positions of the separation regions MS may be removed, and the separation holes may be expanded and connected to each other through cleaning, or the like, thereby forming openings connected to each other in the X-direction as illustrated in FIG. 2. As a plurality of separation holes are expanded in a circumferential direction and connected to each other, a side surface forming the separation region MS may have a shape in which a convex curve continues outwardly. However, the present disclosure is not limited thereto. In this manner, the sacrificial insulating layers 218 may be selectively removed with respect to the interlayer insulating layers 220 through wet etching within the expanded openings, and gate electrodes 230 may be formed.

The gate electrodes 230 may be formed by depositing a conductive material in regions from which the sacrificial insulating layers 218 are removed. The conductive material may include, but not be limited to, a metal, polycrystalline silicon, or a metal silicide material. In some example embodiments, a portion of the gate dielectric layer may be formed before the formation of the gate electrodes 230.

After the gate electrodes 230 are formed, separation insulating layers 264 may be formed in openings formed to correspond to the separation regions MS. In an embodiment, insulating regions SS intersecting the upper gate electrode 230U may also be formed.

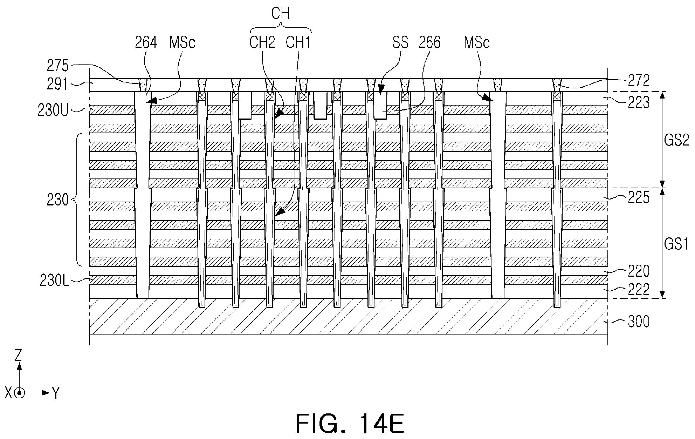

Referring to FIG. 14E, channel studs 272 and address studs 275 may be formed.

A first capping insulating layer 291 may be formed on the uppermost interlayer insulating layer 222 to cover both the upper surfaces of the separation regions MS and the upper surfaces of the channel structures CH.

In the first capping insulating layer 291, a channel stud hole exposing the channel pad 249 of each channel structure CH and an address stud hole exposing upper surfaces of the address separation regions MSc, among the separation regions MS, may be formed simultaneously (e.g., at a substantially similar and/or the same time).

The stud holes may be formed by removing a corresponding region of the first capping insulating layer 291 by etching, and sizes and depths of the channel stud hole and the address stud hole may be substantially similar and/or identical to each other.

Diffusion barriers (e.g., first diffusion barriers 272b and second diffusion barriers 275b) may be stacked along a side surface of a channel stud hole and an address stud hole, and the channel stud hole and the address stud hole may be buried in the first and second diffusion barriers 272b and 275b and a conductive material may be stacked to form the channel studs 272 and the address studs 275. Depending on the shape of the channel stud hole and the address stud hole, a width of an upper portion thereof may be greater than a width of a lower end thereof, and may have an inclined side surface. Accordingly, the address stud hole may be formed on the address separation regions MSc, which are portions of the separation regions MS.

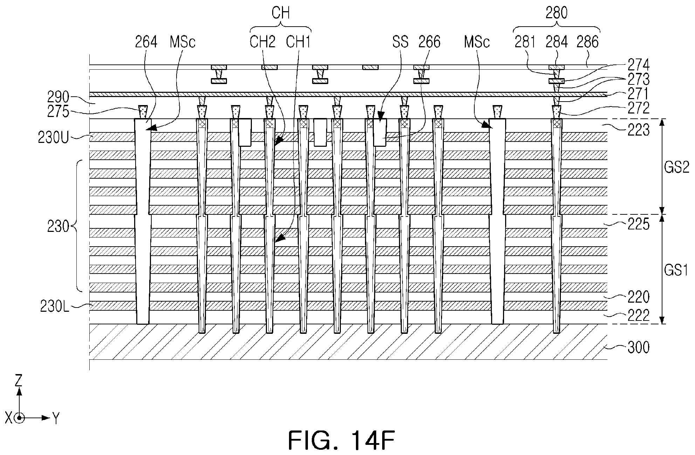

Referring to FIG. 14F, upper interconnection structures 271 to 274 may be formed on the channel studs 272 and the address studs 275.

A second capping insulating layer 295 may be formed to cover the channel studs 272 and the address studs 275, and a portion of the second capping insulating layer 295 may be removed to form a first upper via hole exposing upper surfaces of the channel studs 272. The first upper via hole may be formed to have a smaller size than that of the channel stud hole, and may not be formed on the address studs 275.

A diffusion barrier and a conductive material may be formed in the first upper via hole to form first upper vias 273a connected to the channel studs 272.

Subsequently, a third capping insulating layer 296 covering the first upper vias 273a may be formed, and upper interconnection structures 271 to 274 including first upper interconnection lines 271, second upper vias 273b and second upper interconnection lines 274, connected to the first upper vias 273a, may be formed. The third capping insulating layer 296 may be implemented as a multilayer, and the upper interconnection structures 271 to 274 may be formed by stacking the diffusion barrier and the conductive material in the same manner as the first upper vias 273a.

An upper bonding structure 280 may be formed on the upper interconnection structures 271 to 274.

The upper bonding structure 280 may be formed in a similar manner to forming the lower bonding structure 180. Accordingly, a second semiconductor structure S2, which may be a memory cell structure CELL, may be formed. However, during the manufacturing process of the semiconductor device 10, the second semiconductor structure S2 may further include a base substrate 300.

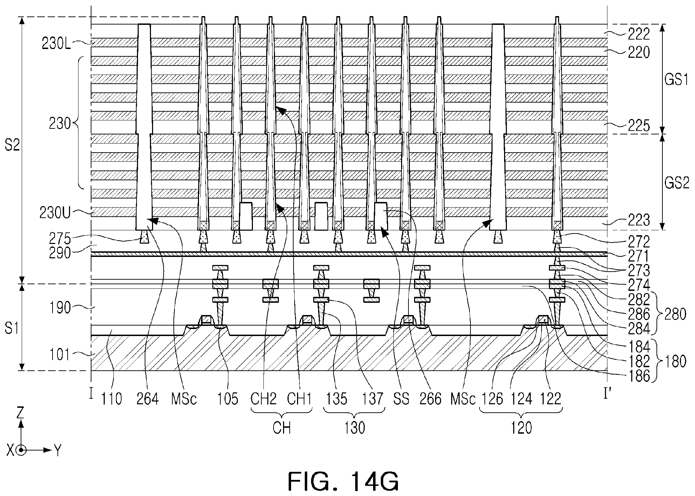

Referring to FIG. 14G, a first semiconductor structure S1, which may be a peripheral circuit structure PERI, and the second semiconductor structure S2, which may be a memory cell structure CELL, may be bonded to each other.

The first semiconductor structure S1 and the second semiconductor structure S2 may be connected by bonding the lower bonding pad 184 and the upper bonding pad 284 by applying pressure. The lower bonding insulating layer 186 and the upper bonding insulating layer 286 may be bonded and connected by applying pressure. The second semiconductor structure S2 may be bonded on the first semiconductor structure S1 so that the upper bonding pad 284 faces downwardly. The first semiconductor structure S1 and the second semiconductor structure S2 may be directly bonded without the intervention of an adhesive such as, for example, a separate adhesive layer.

In a state in which the first semiconductor structure S1 and the second semiconductor structure S2 are bonded to each other, the base substrate 300 exposed to an upper portion of the second semiconductor structure S2 may be removed, and lower portions of the channel structures CH may be exposed. In an embodiment, the information storage structure 245 on the second portion of the exposed channel structure CH may be removed. The information storage structure 245 may be removed by a photolithography process and an etching process such as, but not limited to, wet etching and/or dry etching. Accordingly, in the second portion of the channel structure CH protruding onto the first and second stack structures GS1 and GS2, a protrusion portion 240a may be disposed by exposing the channel layer 240. Accordingly, the channel layer 240 of the second portion may be in direct contact with the first conductive layer 201.

As illustrated in FIG. 3, the first conductive layer 201 may be formed to cover an entire cell region R1. The first conductive layer 201 may be formed by depositing a semiconductor layer, such as, but not limited to, a crystalline silicon layer (e.g., a polycrystalline silicon layer). The first conductive layer 201 may be formed to have a variation along the protruding channel structures CH, but may be formed to a predetermined thickness so that an upper surface thereof is substantially flat. The second conductive layer 202 may be formed on the first conductive layer 201. That is, the second conductive layer 202 may be formed in multiple layers. A buffer layer may be formed conformally to entirely cover the second conductive layer 202, and an oxide film, for example, a silicon oxide (SiO₂) film, may be formed as the buffer layer.

In a structure in which two or more semiconductor structures are bonded, when performing an operation error inspection, the bonded structure may be recut to capture an image thereof, and a position of an error point may be identified thereby. In this case, in a cell structure captured from the cut surface, it may be difficult to identify the position of error points because repetitive circuit patterns, such as bit lines and studs in channel structures, are captured. Accordingly, by arranging address studs for identifying the position of the error points according to a predetermined rule, the position of the error point may be calculated according to an arrangement form of the corresponding address studs.

The address studs may be disposed on separation regions, so that the address studs may be disposed in a position clearly distinguished from the studs on a channel structure, and may serve as an indicator of the position of the error point through various arrangements. In addition, a block address may also be identified by regularly changing an arrangement of the address studs according to the position of the separation region.

Accordingly, a highly reliable semiconductor device and a data storage system including the same may be provided through an error inspection having improved reliability.

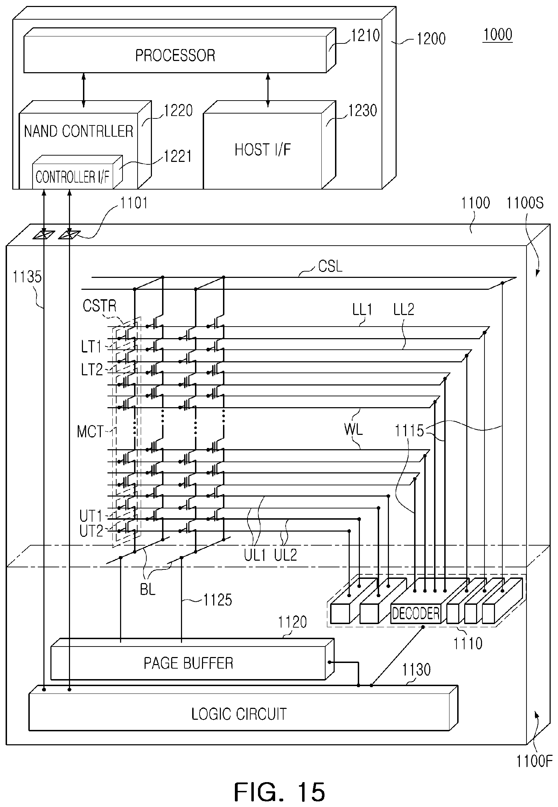

FIG. 15 is a schematic diagram of a data storage system including a semiconductor device, according to example embodiments.

Referring to FIG. 15, a data storage system 1000 may include a semiconductor device 1100 and a controller 1200 electrically connected to the semiconductor device 1100. The data storage system 1000 may be a storage device including one or more semiconductor devices 1100 or an electronic device including the storage device. For example, the data storage system 1000 may be and/or may include a solid state drive (SSD) device, a universal serial bus (USB) device, a computing system, a medical device, or a communication device, including one or more semiconductor devices 1100.

The semiconductor device 1100 may be a nonvolatile memory device, and may be, for example, a NAND flash memory device described above with reference to FIGS. 1 to 13. The semiconductor device 1100 may include a first semiconductor structure 1100F and a second semiconductor structure 1100S on the first semiconductor structure 1100F. According to example embodiments, the first semiconductor structure 1100F may be disposed next to the second semiconductor structure 1100S. The first semiconductor structure 1100F may be and/or may include a peripheral circuit structure including a decoder circuit 1110, a page buffer 1120, and a logic circuit 1130. The second semiconductor structure 1100S may be and/or may include a memory cell structure including a bit line BL, a common source line CSL, word lines WL, gate upper lines (e.g., a first gate upper line UL1 and a second gate upper line UL2), gate lower lines (e.g., a first gate lower line LL1 and a second gate lower line LL2), and memory cell strings CSTR between the bit line BL and the common source line CSL.

In the second semiconductor structure 1100S, each memory cell string CSTR may include lower transistors (e.g., a first lower transistor LT1 and a second lower transistor LT2) adjacent to the common source line CSL, upper transistors (e.g., a first upper transistor UT1 and a second upper transistor UT2) adjacent to a bit line BL, and a plurality of memory cell transistors MCT disposed between the first and second lower transistors LT1 and LT2 and the first and second upper transistors UT1 and UT2. The number of lower transistors LT1 and LT2 and the number of upper transistors UT1 and UT2 may be variously changed, according to example embodiments.

According to example embodiments, the first and second upper transistors UT1 and UT2 may include string select transistors, and the first and second lower transistors LT1 and LT2 may include ground select transistors. The first and second gate lower lines LL1 and LL2 may be gate electrodes of the first and second lower transistors LT1 and LT2, respectively. The word lines WL may be gate electrodes of memory cell transistors MCT, and the first and second gate upper lines UL1 and UL2 may be gate electrodes of the first and second upper transistors UT1 and UT2, respectively.

According to example embodiments, the first and second lower transistors LT1 and LT2 may include ground select transistors connected to each other in series. The first and second upper transistors UT1 and UT2 may include string select transistors connected to each other in series.

The common source line CSL, the first and second gate lower lines LL1 and LL2, the word lines WL, and the first and second gate upper lines UL1 and UL2 may be electrically connected to the decoder circuit 1110 through first interconnection lines 1115 extending from the first semiconductor structure 1100F to the second semiconductor structure 1100S. The bit lines BL may be electrically connected to the page buffer 1120 through second interconnection lines 1125 extending from the first semiconductor structure 1100F to the second semiconductor structure 1100S.

In the first semiconductor structure 1100F, the decoder circuit 1110 and the page buffer 1120 may perform a control operation for at least one selected memory cell transistor, among the plurality of memory cell transistors MCT. The decoder circuit 1110 and the page buffer 1120 may be controlled by the logic circuit 1130. The semiconductor device 1100 may communicate with the controller 1200 through an input/output pad 1101 electrically connected to the logic circuit 1130. The input/output pad 1101 may be electrically connected to the logic circuit 1130 through an input/output interconnection line 1135 extending from the first semiconductor structure 1100F to the second semiconductor structure 1100S.

The controller 1200 may include a processor 1210, a NAND controller 1220, and a host interface 1230. According to example embodiments, the data storage system 1000 may include a plurality of semiconductor devices 1100, and the controller 1200 may control the plurality of semiconductor devices 1100.

The processor 1210 may control an overall operation of the data storage system 1000 including the controller 1200. The processor 1210 may operate according to a predetermined firmware, and may control the NAND controller 1220 to access the semiconductor device 1100. The NAND controller 1220 may include a NAND interface 1221 processing communication with the semiconductor device 1100. Through the NAND interface 1221, control commands for controlling the semiconductor device 1100, data to be written to the memory cell transistors MCT of the semiconductor device 1100, data to be read from the memory cell transistors MCT of the semiconductor device 1100, or the like, may be transmitted. The host interface 1230 may provide a communication function between the data storage system 1000 and the external host. When a control command is received from the external host through the host interface 1230, the processor 1210 may control the semiconductor device 1100 in response to the control command.

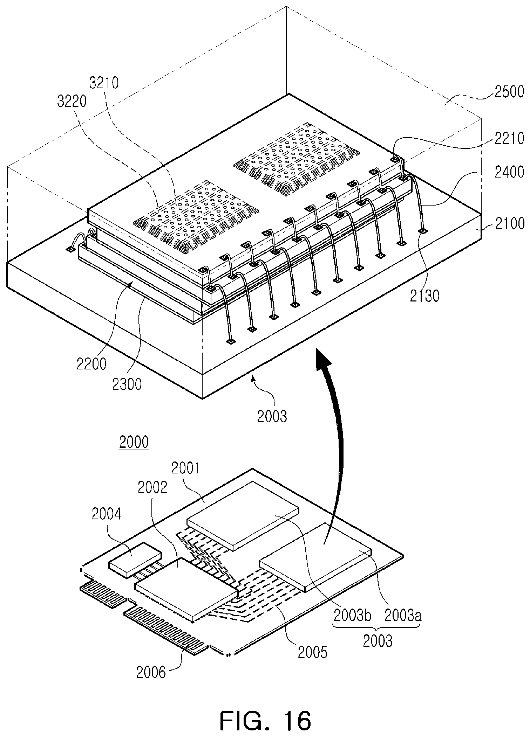

FIG. 16 is a perspective view schematically illustrating a data storage system including a semiconductor device, according to an example embodiment.

Referring to FIG. 16, a data storage system 2000, according to an example embodiment of the present disclosure, may include a main board 2001, a controller 2002 mounted on the main board 2001, one or more semiconductor packages 2003, and a dynamic random-access memory (DRAM) 2004. The semiconductor package 2003 and the DRAM 2004 may be connected to the controller 2002 by interconnection patterns 2005 formed on the main board 2001.

The main board 2001 may include a connector 2006 including a plurality of pins coupled to the external host. The number and arrangement of the plurality of pins in the connector 2006 may vary depending on a communication interface between the data storage system 2000 and the external host. According to example embodiments, the data storage system 2000 may communicate with the external host according to any one of interfaces such as, but not limited to, USB, peripheral component interconnect (PCI) express (PCI-Express), serial advanced technology attachment (SATA), M-Phy for universal flash storage (UFS), or the like. According to example embodiments, the data storage system 2000 may operate by power supplied from the external host through the connector 2006. The data storage system 2000 may further include a power management integrated circuit (PMIC) distributing the power supplied from the external host to the controller 2002 and the semiconductor package 2003.

The controller 2002 may write data to the semiconductor package 2003 and/or read data from the semiconductor package 2003, and may improve operating speed of the data storage system 2000.

The DRAM 2004 may be and/or may include a buffer memory for mitigating a speed difference between the semiconductor package 2003, which may be a data storage space, and the external host. The DRAM 2004 included in the data storage system 2000 may also function as a type of cache memory, and may provide a space for temporarily storing data in a control operation for the semiconductor package 2003. When the DRAM 2004 is included in the data storage system 2000, the controller 2002 may further include a DRAM controller for controlling DRAM 2004, in addition to a NAND controller for controlling the semiconductor package 2003.

The semiconductor package 2003 may include first and second semiconductor packages 2003a and 2003b spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, semiconductor chips 2200 on the package substrate 2100, adhesive layers 2300 disposed on lower surfaces of each of the semiconductor chips 2200, a connection structure 2400 electrically connecting the semiconductor chips 2200 and the package substrate 2100, and a molding layer 2500 covering the semiconductor chips 2200 and the connection structure 2400 on the package substrate 2100.

The package substrate 2100 may be a printed circuit board (PCB) including package upper pads 2130. Each semiconductor chip 2200 may include an input/output pad 2210. The input/output pad 2210 may correspond to the input/output pad 1101 of FIG. 15. Each of the semiconductor chips 2200 may include gate stack structures 3210 and channel structures 3220. Each of the semiconductor chips 2200 may include the semiconductor device described above with reference to FIGS. 1 to 13.

According to example embodiments, the connection structure 2400 may be a bonding wire for electrically connecting the input/output pad 2210 and the package upper pads 2130. Accordingly, in each of the first and second semiconductor packages 2003a and 2003b, the semiconductor chips 2200 may be electrically connected to each other in a bonding wire manner and may be electrically connected to the package upper pads 2130 of the package substrate 2100. According to example embodiments, in each of the first and second semiconductor packages 2003a and 2003b, the semiconductor chips 2200 may be electrically connected to each other by a connecting structure including a through-silicon via (TSV), instead of the connecting structure 2400 in a bonding wire manner.

According to example embodiments, the controller 2002 and the semiconductor chips 2200 may be included in one package. According to an example embodiment, the controller 2002 and the semiconductor chips 2200 may be mounted on a separate interposer substrate different from a main substrate 2001, and the controller 2002 and semiconductor chips 2200 may be connected to each other by interconnection lines formed on the interposer substrate.

The present disclosure is not limited to the above-described embodiments and the accompanying drawings but may be defined by the appended claims. Therefore, those of ordinary skill in the art may make various replacements, modifications, or changes, and combinations of example embodiments without departing from the scope of the present disclosure defined by the appended claims, and these replacements, modifications, or changes should be construed as being included in the scope of the present disclosure.

## Claims

1. A semiconductor device, comprising:
a first semiconductor structure (S1) comprising:
a first substrate (101);
circuit elements (120) on the first substrate (101);
a lower interconnection structure (130) coupled with the circuit elements (120); and
a lower bonding structure (180) coupled with the lower interconnection structure (130); and
a second semiconductor structure (S2) comprising:
an upper bonding structure (280) bonded to the lower bonding structure (180);
a conductive layer (201);
a stack structure (GS1, GS2) comprising interlayer insulating layers (220) and gate electrodes (230) laminated in a first direction (Z) below the conductive layer (201), the first direction (Z) being perpendicular to an upper surface of the conductive layer (201);
a plurality of separation regions (MS) at least partially penetrating through the stack structure (GS1, GS2), extending in a second direction (X), and spaced apart from each other in a third direction (Y), the second direction (X) being perpendicular to the first direction (Z), the third direction (Y) being perpendicular to the first direction (Z) and the second direction (X);
channel structures (CH) comprising a channel layer (240) and at least partially penetrating through the stack structure (GS1, GS2) in the first direction (Z);
a plurality of address studs (275) spaced apart from each other by a first separation distance (I1) in the second direction (X) below at least one separation region (MS) of the plurality of separation regions (MS);
a plurality of channel studs (272) below the channel structures (CH); and
an upper interconnection structure (271, 273, 274) below the stack structure (GS1, GS2), coupled with the plurality of channel studs (272), and spaced apart from the plurality of address studs (275).

2. The semiconductor device of claim 1, wherein each address stud (275) of the plurality of address studs (275) comprises a first upper surface (Sb), a first lower surface, and a first side surface between the first upper surface (Sb) and the first lower surface,
wherein each channel stud (272) of the plurality of channel studs (272) comprises a second upper surface, a second lower surface, and a second side surface between the second upper surface and the second lower surface, and
wherein the first lower surfaces of the plurality of address studs (275) are disposed on a same level as the second lower surfaces of the plurality of channel studs (272).

3. The semiconductor device of claim 2, wherein the first upper surfaces (Sb) of the plurality of address studs (275) are disposed below third lower surfaces (Sa) of the at least one separation region (MS),
wherein, for each address stud (275) of the plurality of address studs (275), a width of the first upper surface (Sb) is less than a width (W2) of the first lower surface, and
wherein widths (W1) of the third lower surfaces (Sa) of the at least one separation region (MS) are greater than the width (W2) of the first lower surface of each address stud of the plurality of address studs (275).

4. The semiconductor device of claim 3, wherein the third lower surfaces (Sa) of the at least one separation region (MS) are spaced apart from the first upper surface (Sb) of each address stud (275) of the plurality of address studs (275) in the first direction (Z).

5. The semiconductor device of claim 3 or 4, further comprising:
a base layer (298) between the third lower surfaces (Sa) of the at least one separation region (MS) and the first upper surface (Sb) of each address stud (275) of the plurality of address studs (275).

6. The semiconductor device of any one of claims 2 to 5, wherein, for each address stud (275) of the plurality of address studs (275), a first reference line (ℓ₁) passing through a center of the upper surface in the first direction (Z) is offset with respect to a second reference line (ℓ₀) passing through a center of a width of the at least one separation region (MS) in the third direction (Y).

7. The semiconductor device of any one of claims 2 to 6, further comprising:
an upper insulating layer (295) between the first lower surface of each address stud (275) of the plurality of address studs (275) and the upper interconnection structure (271, 273, 274),
wherein the plurality of address studs (275) are isolated from the upper interconnection structure (271, 273, 274) by the upper insulating layer (295).

8. The semiconductor device of any one of claims 1 to 7, wherein a first length (h1) of each address stud (275) of the plurality of address studs (275) in the first direction (Z) is equal to a second length (h1) of each channel stud (272) of the plurality of channel studs (272) in the first direction (Z).

9. The semiconductor device of any one of claims 1 to 7, wherein a first length (h2) of each address stud (275) of the plurality of address studs (275) in the first direction (Z) is less than a second length (h1) of each channel stud (272) of the plurality of channel studs (272) in the first direction (Z).

10. The semiconductor device of any one of claims 1 to 9, wherein the upper interconnection structure (271, 273, 274) comprises bit lines (BL) coupled with the plurality of channel studs (272), extending in the third direction (Y) and spaced apart from each other in the second direction (X), and
wherein the first separation distance (I1) is a multiple of a pitch of the bit lines (BL).

11. The semiconductor device of claim 1, further comprising:
an upper gate electrode (293) between the channel structures (CH) and the plurality of channel studs (272);
upper channel structures (CH3) at least partially penetrating through the upper gate electrode (293) and coupled with each of the channel structures (CH); and
insulating regions (SS) at least partially penetrating through the upper gate electrode (293) and disposed below the plurality of separation regions (MS),
wherein the plurality of address studs (275) are disposed below the insulating regions (SS).

12. The semiconductor device of claim 11, wherein a first reference line (ℓ₁) passing through a center of an upper surface of an address stud (275) of the plurality of address studs (275) in the first direction (Z) is coaxial with a second reference line (ℓ₀) passing through a center of a width of a separation region (MS) of the at least one separation region (MS) in the third direction (Y) and is offset in the third direction (Y) from a third reference line (ℓ₂) passing through a center of a width of an insulating region (SS) of the insulating regions (SS) which is closest to the address stud (275) in the third direction (Y).

13. The semiconductor device of claim 11 or 12, wherein a width of the upper surface (Sb) of each address stud (275) of the plurality of address studs (275) is less than a width of a lower surface of each separation region (SS) of the plurality of separation regions (MS).

14. The semiconductor device of any one of claims 1 to 13, wherein the plurality of separation regions (MS) comprise address separation groups comprising first address separation regions (MSc) and second address separation regions (MSc) adjacent to the first address separation regions in the third direction (Y);
the plurality of address studs (275) spaced apart from each other by multiples (r) of a unit separation distance (I1) in the second direction (X), and disposed below the first address separation regions (MSc) and the second address separation regions (MSc).

15. A data storage system, comprising:
a semiconductor storage device (1110) according to any one of the preceding claims; and
a controller (1200),
wherein the semiconductor storage device (1110) further comprises an input/output pad (1101) coupled with the circuit elements (120), and
wherein the controller (1200) is coupled with the semiconductor storage device (1100) via the input/output pad (1101) and configured to control the semiconductor storage device (1200).
